# EUROPEAN PATENT APPLICATION

(11) **EP 4 654 769 A1**
(43) Date of publication of application: **26.11.2025**
(21) Application number: 25177610.0
(22) Date of filing: 20.05.2025
(51) Int. Cl.: H05K 7/20

(54) **POWER CONVERSION DEVICE**

(30) Priority: 22.05.2024 CN 202421123717 U
(71) Applicant: Huawei Digital Power Technologies Co., Ltd., Shenzhen, Guangdong 518043 (CN)
(72) Inventor: LI, Maofan, Shenzhen, 518043 (CN); ZHANG, Yuan, Shenzhen, 518043 (CN)
(74) Representative: Isarpatent

(57) **Abstract**

This application provides a power conversion device. The power conversion device includes a housing, a power module, and a heat sink. The housing includes a first sub-housing and a second sub-housing. The first sub-housing includes an accommodation cavity. The accommodation cavity extends along a first direction and has an accommodation opening. Along the first direction, the second sub-housing is disposed on one side of the first sub-housing. The second sub-housing covers the accommodation opening and closes the accommodation cavity. The power module is accommodated in the accommodation cavity. Along the first direction, the heat sink is disposed on one side of the first sub-housing and backs the second sub-housing. The heat sink is connected to the power module in a thermally conductive manner. An accommodation groove is provided on one side of the first sub-housing. The accommodation groove extends along the first direction and has a first opening. The first opening of the accommodation groove backs the accommodation cavity along the first direction. The heat sink is accommodated in the accommodation groove. Because the heat sink is accommodated in the accommodation groove, space utilization of the housing is greatly improved while heat dissipation efficiency for the power module is ensured. This facilitates a miniaturization design for the power conversion device.

## Description

### TECHNICAL FIELD

This application relates to the field of electronic technologies, and in particular, to a power conversion device.

### BACKGROUND

In an existing power conversion device, a power module is accommodated in a housing, and a heat sink is stacked outside the housing. Heat generated by the power module during operation is transferred to the outside through the heat sink. However, because both the heat sink and the housing need to occupy space, the existing power conversion device has the following disadvantages: A size is large, and it is inconvenient to implement a miniaturization design.

### UTILITY MODEL CONTENT

This application provides a power conversion device. The power conversion device includes a housing, a power module, and a heat sink. The housing includes a first sub-housing and a second sub-housing. The first sub-housing includes an accommodation cavity. The accommodation cavity extends along a first direction and has an accommodation opening. Along the first direction, the second sub-housing is disposed on one side of the first sub-housing. The second sub-housing covers the accommodation opening and closes the accommodation cavity. The power module is accommodated in the accommodation cavity. Along the first direction, the heat sink is disposed on one side of the first sub-housing and backs the second sub-housing. The heat sink is connected to the power module in a thermally conductive manner. An accommodation groove is provided on one side of the first sub-housing. The accommodation groove extends along the first direction and has a first opening. The first opening of the accommodation groove backs the accommodation cavity along the first direction. The heat sink is accommodated in the accommodation groove.

In the power conversion device provided in this embodiment of this application, heat generated by the power module during operation is transferred out of the housing through the heat sink, to quickly dissipate heat for the power module. Compared with an existing power conversion device, in the power conversion device provided in this application, because the heat sink is accommodated in the accommodation groove, space utilization of the housing is greatly improved while heat dissipation efficiency for the power module is ensured. This helps reduce a size of the power conversion device along the first direction, and facilitates a miniaturization design for the power conversion device.

In a possible implementation, the first sub-housing is provided with a first through hole. The first through hole passes through the first sub-housing along the first direction. The first through hole is in communication with the accommodation cavity and the accommodation groove. The heat sink is exposed to the accommodation cavity through the first through hole. The heat sink is in contact with the power module.

The design in which the heat sink is in contact with the power module helps improve efficiency of transferring heat generated by the power module during operation to the heat sink, helps improve efficiency of transferring heat generated by the power module during operation out of the housing through the heat sink, and helps improve heat dissipation efficiency for the power module.

In a possible implementation, the accommodation groove passes through the first sub-housing along a second direction and has a second opening. The heat sink is exposed out of the housing through the first opening and the second opening. The second direction is perpendicular to the first direction.

The design in which the accommodation groove extends along the first direction and has the first opening and the accommodation groove passes through the first sub-housing along the second direction and has the second opening ensures that the heat sink can be exposed out of the housing through the first opening and the second opening. This helps increase a contact area between the heat sink and an external environment of the housing, helps improve efficiency of transferring heat generated by the power module during operation out of the housing through the heat sink, and helps improve heat dissipation efficiency for the power module.

In a possible implementation, the power conversion device includes a circuit board and an inductor. The circuit board is accommodated in the accommodation cavity. Along the first direction, the circuit board is installed on one side of the power module and backs the first sub-housing. The inductor is accommodated in the accommodation groove. The inductor is spaced away from the heat sink. The inductor is electrically connected to the circuit board.

The design in which the inductor is accommodated in the accommodation groove not only ensures that heat generated by the inductor during operation can be directly transferred out of the housing to quickly dissipate heat for the inductor, but also greatly improves space utilization of the housing. This helps reduce the size of the power conversion device along the first direction, and facilitates a miniaturization design for the power conversion device.

In a possible implementation, the first sub-housing is provided with a second through hole. The second through hole passes through the first sub-housing along the first direction. The second through hole is in communication with the accommodation cavity and the accommodation groove. The second through hole is spaced away from the first through hole. The power conversion device includes a connector. The connector passes through the second through hole, and the connector is disposed between the inductor and the circuit board; or the inductor passes through the second through hole, and the inductor is plug-connected to the circuit board.

The design of the second through hole facilitates an electrical connection between the inductor and the circuit board in a manner including but not limited to wiring or plug-connection. This helps reduce difficulty in the electrical connection between the inductor and the circuit board, and helps reduce processing costs of the power conversion device.

In a possible implementation, the inductor includes an inductor housing and an inductor body. An installation slot is provided on one side of the inductor housing. The installation slot extends along the first direction and has an opening. The opening of the installation slot faces the accommodation cavity along the first direction. The inductor body is accommodated in the installation slot. The inductor body is electrically connected to the circuit board. The inductor housing is provided with a thermally conductive fin. The thermally conductive fin is located outside the installation slot.

Heat generated by the inductor body during operation is transferred to the external environment through the inductor housing. The design in which the inductor housing is provided with the thermally conductive fin helps increase a heat dissipation area in which heat generated by the inductor body during operation is transferred to the outside through the inductor housing, helps improve efficiency of transferring heat generated by the inductor body during operation to the outside through the inductor housing, helps improve heat dissipation efficiency for the inductor body, and helps improve heat dissipation efficiency for the inductor.

In a possible implementation, the power conversion device includes an auxiliary module. Along the first direction, the auxiliary module is installed on one side of the circuit board and faces the power module. The auxiliary module is accommodated in the accommodation cavity. A projection of the auxiliary module along a third direction overlaps a projection of the accommodation groove along the third direction. The third direction is perpendicular to the first direction.

The design in which the projection of the auxiliary module along the third direction overlaps the projection of the accommodation groove along the third direction helps improve space utilization of the accommodation cavity, helps reduce a size of the housing along the first direction, helps improve space utilization of the housing, facilitates a miniaturization design for the housing, facilitates a miniaturization design for the power conversion device, and helps improve power density of the power conversion device.

In a possible implementation, the accommodation cavity includes a first cavity and a second cavity. Along the third direction, the second cavity is located on one side of the first cavity and is in communication with the second cavity. A depth size of the second cavity is greater than a depth size of the first cavity. A projection of the first cavity along the first direction overlaps a projection of the accommodation groove along the first direction. A projection of the second cavity along the third direction overlaps the projection of the accommodation groove along the third direction. The power module is accommodated in the first cavity. The auxiliary module is accommodated in the second cavity.

This ensures that both the power module and the auxiliary module can be accommodated in the accommodation cavity. On this basis, the depth size of the first cavity adapts to the size of the power module along the first direction, and the depth size of the second cavity adapts to a size of the auxiliary module along the first direction. The design in which the power module is accommodated in the first cavity and the auxiliary module is accommodated in the second cavity can ensure that the projection of the auxiliary module along the third direction overlaps the projection of the accommodation groove along the third direction. This helps improve space utilization of the accommodation cavity, helps reduce the size of the housing along the first direction, helps improve space utilization of the housing, facilitates a miniaturization design for the housing, facilitates a miniaturization design for the power conversion device, and helps improve power density of the power conversion device.

In a possible implementation, the power conversion device includes a capacitor. Along the first direction, the capacitor is installed on one side of the circuit board and faces the power module. The capacitor is accommodated in the second cavity. The capacitor is spaced away from the auxiliary module. A projection of the capacitor along the third direction overlaps the projection of the accommodation groove along the third direction.

The design in which the capacitor is accommodated in the second cavity can ensure that the projection of the capacitor along the third direction overlaps the projection of the accommodation groove along the third direction. This helps improve space utilization of the accommodation cavity, helps reduce the size of the housing along the first direction, helps improve space utilization of the housing, facilitates a miniaturization design for the housing, facilitates a miniaturization design for the power conversion device, and helps improve power density of the power conversion device.

In a possible implementation, the accommodation cavity includes a third cavity. Along the third direction, the third cavity is located on one side of the first cavity and backs the second cavity. The third cavity is in communication with the first cavity. A depth size of the third cavity is greater than the depth size of the first cavity. A projection of the third cavity along the third direction overlaps the projection of the accommodation groove along the third direction. The power conversion device includes a capacitor. Along the first direction, the capacitor is installed on one side of the circuit board and faces the power module. The capacitor is accommodated in the third cavity. A projection of the capacitor along the third direction overlaps the projection of the accommodation groove along the third direction.

The design in which the capacitor is accommodated in the third cavity can ensure that the projection of the capacitor along the third direction overlaps the projection of the accommodation groove along the third direction. This helps improve space utilization of the accommodation cavity, helps reduce the size of the housing along the first direction, helps improve space utilization of the housing, facilitates a miniaturization design for the housing, facilitates a miniaturization design for the power conversion device, and helps improve power density of the power conversion device.

In a possible implementation, the power conversion device includes an air director. Along the first direction, the air director is disposed on one side of the heat sink and backs the first sub-housing. The air director covers the accommodation groove. The air director is provided with an air intake hole and an air exhaust hole. The air intake hole extends along the first direction. The air intake hole is in communication with the accommodation groove. The air exhaust hole extends along a second direction. The air exhaust hole is in communication with the accommodation groove. The second direction is perpendicular to the first direction.

Cooling air may flow from the outside of the air director to the heat sink through the air intake hole, and then flow out of the air director from the heat sink through the air exhaust hole, to dissipate heat for the heat sink and therefore dissipate heat for the power module. In the design of the air director, the cooling air can be directed. This helps improve heat dissipation efficiency for the heat sink, and helps improve heat dissipation efficiency for the power module.

In a possible implementation, the power conversion device includes a fan. Along the first direction, the fan is disposed on one side of the air director and faces the heat sink. The fan is spaced away from the heat sink. A projection of the fan along the first direction overlaps a projection of the air intake hole along the first direction.

The fan is configured to produce cooling air. The cooling air produced by the fan may flow from the outside of the air director to the heat sink through the air intake hole, and then flow out of the air director from the heat sink through the air exhaust hole, to dissipate heat for the heat sink and therefore dissipate heat for the power module. The design in which the fan is disposed on one side of the air director and faces the heat sink helps improve space utilization of the power conversion device, helps reduce the size of the power conversion device along the first direction, and facilitates a miniaturization design for the power conversion device. In addition, the fan can be prevented from being exposed out of the air director, so that the design is appealing. In addition, the fan can be prevented from being affected by the external environment during operation. This helps improve service life of the fan.

In a possible implementation, a first baffle plate and a second baffle plate are disposed on one side of the air director. Both the first baffle plate and the second baffle plate face the heat sink along the first direction. The first baffle plate and the second baffle plate are located on two sides of the fan and are spaced away from the fan along the second direction.

In the design of the first baffle plate and the second baffle plate, cooling air produced by the fan can be directed, to ensure that cooling air flowing into the air director through the air intake hole stably flows to the heat sink along the first direction. This helps improve efficiency of cooling air flowing through the heat sink, helps improve heat dissipation efficiency for the heat sink, and helps improve heat dissipation efficiency for the power module.

In a possible implementation, the air director includes a stationary portion and a slidable portion. The slidable portion is slidably connected to the stationary portion along the second direction. Along the first direction, the stationary portion is disposed on one side of the heat sink and backs the first sub-housing. The slidable portion is located between the stationary portion and the heat sink. Both the air intake hole and the air exhaust hole are provided on the stationary portion. The slidable portion is provided with an air vent. The air vent is in communication with the air intake hole. The fan is disposed on one side of the slidable portion and backs the stationary portion. The projection of the fan along the first direction overlaps a projection of the air vent along the first direction.

The design in which the slidable portion is slidably connected to the stationary portion along the second direction and the fan is disposed on one side of the slidable portion and backs the stationary portion ensures that the fan can be maintained or replaced after the slidable portion is driven to slide relative to the stationary portion, to avoid removing the air director and then maintaining or replacing the fan. This helps reduce difficulty in maintaining or replacing the fan, and facilitates maintenance or replacement of the fan.

In a possible implementation, the stationary portion is provided with a sliding slot. The sliding slot extends along the second direction. The sliding slot extends along the first direction and has a sliding slot opening. The sliding slot opening faces the heat sink along the first direction. The stationary portion is provided with a fitting hole. The fitting hole passes through the stationary portion along the second direction. The slidable portion is slidably connected to the sliding slot along the second direction, and the slidable portion movably passes through the fitting hole along the second direction.

The design in which the slidable portion is slidably connected to the sliding slot along the second direction and the slidable portion movably passes through the fitting hole along the second direction ensures that the slidable portion can slide relative to the stationary portion along the second direction, and the slidable portion can be pulled out of the fitting hole along the sliding slot, so that the fan disposed on the slidable portion can be maintained or repaired. This helps reduce difficulty in maintaining or replacing the fan, and facilitates maintenance or replacement of the fan.

### BRIEF DESCRIPTION OF DRAWINGS

To describe technical solutions in embodiments of this application or in the background more clearly, the following describes accompanying drawings used in embodiments of this application or in the background.
FIG. 1 is a block diagram of a structure of cooperation between a power conversion system, a photovoltaic module, and a power grid according to an embodiment of this application;
FIG. 2 is a three-dimensional diagram of a structure of a power conversion system shown in FIG. 1;
FIG. 3 is a schematic three-dimensional exploded view of a structure of a power conversion system shown in FIG. 2;
FIG. 4 is a three-dimensional diagram of a structure of a power conversion device in a power conversion system shown in FIG. 3 from another perspective;
FIG. 5 is a diagram of a structure of a power conversion device shown in FIG. 4 that is cut along a line A-A;
FIG. 6 is a schematic three-dimensional exploded view of a structure of a power conversion device shown in FIG. 5;
FIG. 7 is a diagram of a partial structure of a housing, cut along a line A-A, of a power conversion device shown in FIG. 4;
FIG. 8 is a schematic three-dimensional exploded view of a structure of a housing of a power conversion device shown in FIG. 4 from another perspective;
FIG. 9 is a schematic three-dimensional exploded view of a structure of a housing (a third housing is omitted) of a power conversion device shown in FIG. 4;
FIG. 10 is a schematic three-dimensional exploded view of a structure of a power conversion device shown in FIG. 4 from another perspective, where a second sub-housing, a fastener, an inductor, and a heat dissipation assembly are omitted;
FIG. 11 is a diagram of a partial structure of a power conversion device (an air director, a mounting kit, and a fan are omitted) shown in FIG. 4 that is cut along a line B-B;
FIG. 12 is a schematic three-dimensional exploded view of a partial structure of a power conversion device shown in FIG. 11;
FIG. 13 is a three-dimensional diagram of a structure of an assembled inductor of a power conversion device shown in FIG. 12 from another perspective;
FIG. 14 is a three-dimensional diagram of a structure of a heat sink of a power conversion device shown in FIG. 12 from another perspective;
FIG. 15 is a three-dimensional diagram of a structure of a heat dissipation assembly (a heat sink is omitted) of a power conversion device shown in FIG. 4 from another perspective;
FIG. 16 is a schematic three-dimensional exploded view of a structure of a heat dissipation assembly shown in FIG. 15; and
FIG. 17 is a diagram of a structure of a power conversion device shown in FIG. 4 that is cut along a line A-A according to another embodiment.

### DESCRIPTION OF EMBODIMENTS

Embodiments of this application provide a power conversion device. The power conversion device is used in a power conversion system. The power conversion system is a system for converting a direct current into an alternating current or converting an alternating current into a direct current. The power conversion device provided in this application helps improve space utilization of a box, and facilitates a miniaturization design for the power conversion device.

The following describes embodiments of this application with reference to accompanying drawings in embodiments of this application.

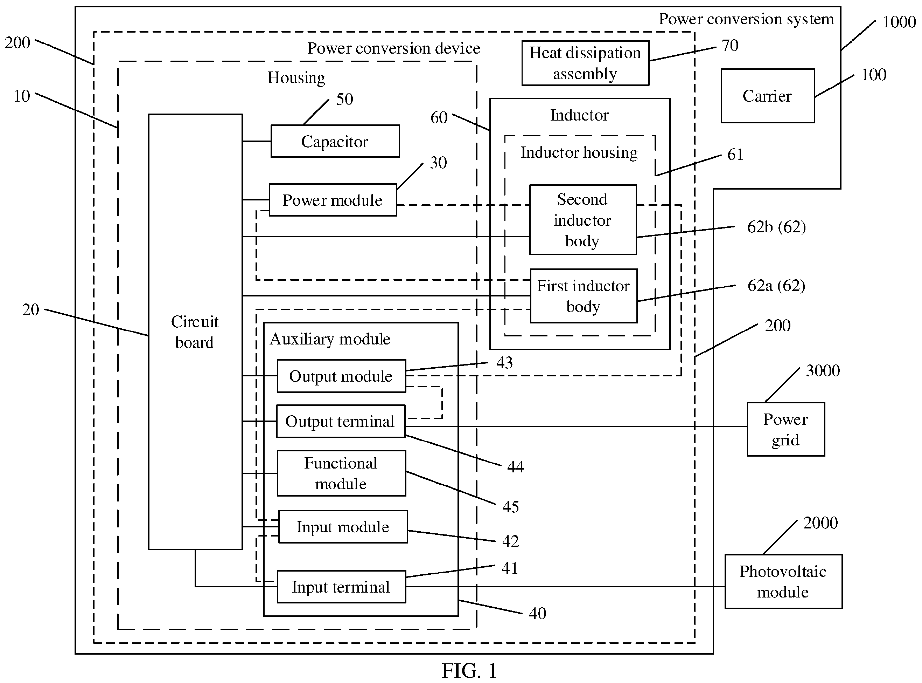

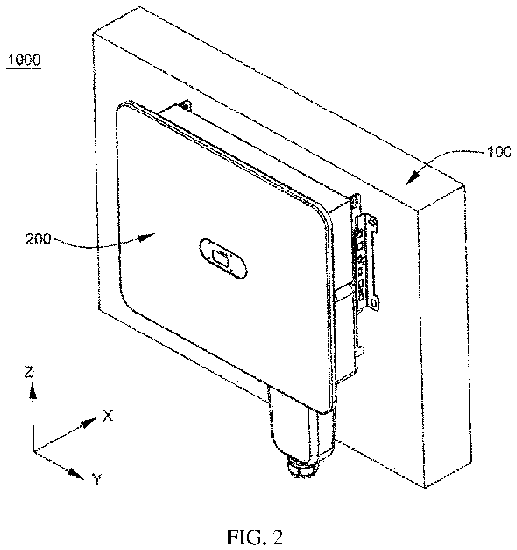

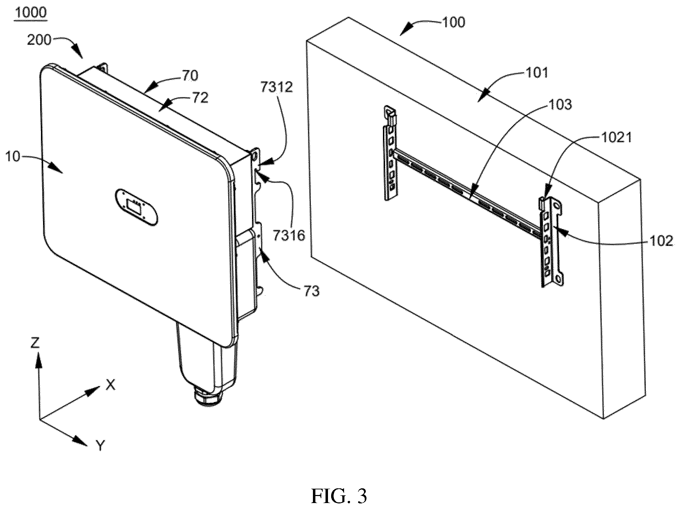

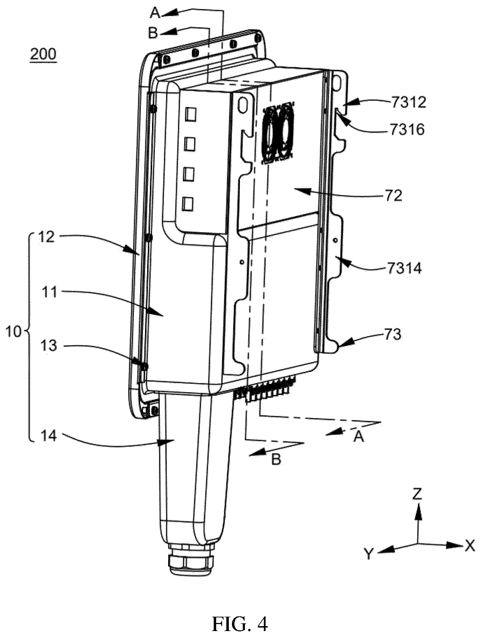

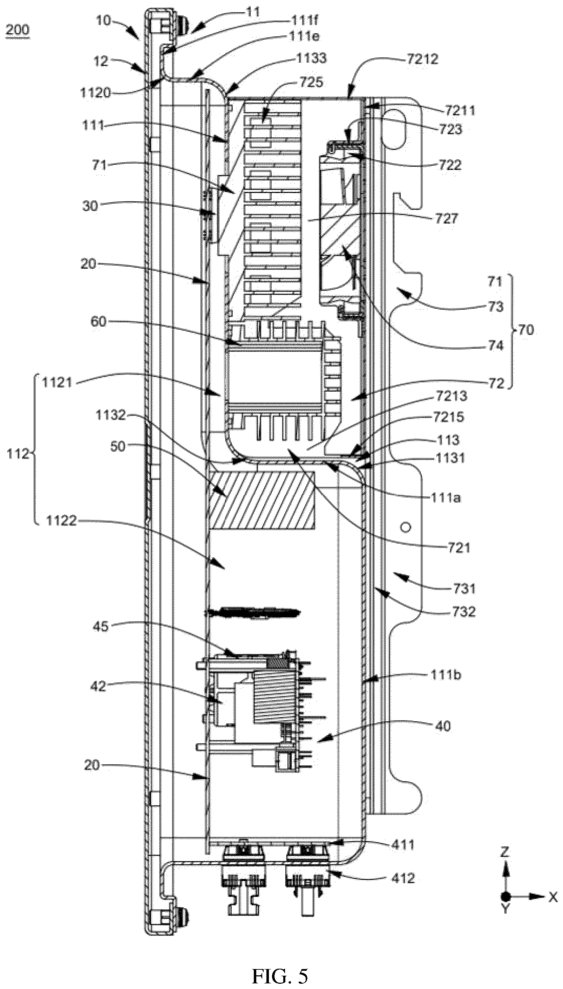

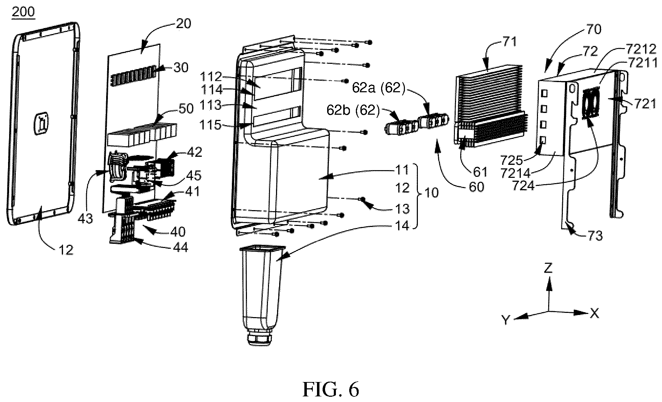

Refer to FIG. 1, FIG. 2, FIG. 3, FIG. 4, FIG. 5, and FIG. 6. FIG. 1 is a block diagram of a structure of cooperation between a power conversion system 1000, a photovoltaic module 2000, and a power grid 3000 according to an embodiment of this application. FIG. 2 is a three-dimensional diagram of a structure of the power conversion system 1000 shown in FIG. 1. FIG. 3 is a schematic three-dimensional exploded view of a structure of the power conversion system 1000 shown in FIG. 2. FIG. 4 is a three-dimensional diagram of a structure of a power conversion device 200 in the power conversion system 1000 shown in FIG. 3 from another perspective. FIG. 5 is a diagram of a structure of the power conversion device 200 shown in FIG. 4 that is cut along a line A-A. FIG. 6 is a schematic three-dimensional exploded view of a structure of the power conversion device 200 shown in FIG. 5.

As shown in FIG. 1, for example, the power conversion system 1000 is configured to convert a direct current output by the photovoltaic module 2000 into an alternating current, and supply the alternating current to the power grid 3000. The power conversion system 1000 includes a carrier 100 and the power conversion device 200. The power conversion device 200 is installed on the carrier 100. The power conversion device 200 is configured to convert a direct current output by the photovoltaic module 2000 into an alternating current, and supply the alternating current to the power grid 3000. For example, the power conversion device 200 is a photovoltaic inverter. In some other embodiments, the power conversion device 200 may alternatively be configured to convert a direct current output by the photovoltaic module 2000 into an alternating current, and supply the alternating current to a load device. The load device may be an electronic device that uses an alternating current, including but not limited to a motor, a fan, an air conditioner, or the like. The power conversion device 200 may alternatively be configured to convert a direct current output by a battery into an alternating current, and supply the alternating current to the motor. The power conversion device 200 may alternatively be an electronic device used for power conversion, for example, a rectifier, a transformer, a converter, or another inverter.

As shown in FIG. 2 and FIG. 3, in some embodiments, the carrier 100 includes a carrier body 101, a fitting piece 102, and a reinforcing piece 103. Along an X-axis direction, the fitting piece 102 is disposed on one side of the carrier body 101. Specifically, the fitting piece 102 is fastened and stacked on one side of the carrier body 101. For example, there are two fitting pieces 102. In some other embodiments, there may alternatively be one, three, or more fitting pieces 102. Along a Y-axis direction, the two fitting pieces 102 are arranged opposite to each other at a spacing. The reinforcing piece 103 is disposed between the two fitting pieces 102. Specifically, the reinforcing piece 103 is fastened and stacked between the two fitting pieces 102. The design of the reinforcing piece 103 helps improve strength of the fitting piece 102, and helps improve structural stability of the carrier 100. The fitting piece 102 is provided with a fitting slot 1021. Along a Z-axis direction, the fitting slot 1021 passes through the fitting piece 102. In addition, the fitting slot 1021 extends along the X-axis direction and has an opening, and the opening of the fitting slot 1021 faces the carrier body 101.

For ease of description, in this application, three directions perpendicular to each other are respectively defined as a first direction (namely, the X-axis direction shown in the figure), a second direction (namely, the Y-axis direction shown in the figure), and a third direction (namely, the Z-axis direction shown in the figure). The second direction is perpendicular to the first direction, and the third direction is perpendicular to the first direction and the second direction.

In some embodiments, along the X-axis direction, the power conversion device 200 is located on one side of the fitting piece 102 and backs the carrier body 101. The power conversion device 200 is mounted on the fitting piece 102. Specifically, the power conversion device 200 is partially inserted into the fitting slot 1021 of the fitting piece 102, and the power conversion device 200 abuts against the fitting piece 102.

As shown in FIG. 4, FIG. 5, and FIG. 6, in some embodiments, the power conversion device 200 includes a housing 10, a circuit board 20, a power module 30, an auxiliary module 40, a capacitor 50, an inductor 60, and a heat dissipation assembly 70. The circuit board 20, the power module 30, the auxiliary module 40, and the capacitor 50 are all accommodated in the housing 10. Both the inductor 60 and the heat dissipation assembly 70 are installed outside the housing 10. The power module 30, the auxiliary module 40, the capacitor 50, and the inductor 60 are all installed on the circuit board 20, and the capacitor 50 is electrically connected to the circuit board 20. The auxiliary module 40 includes an input terminal 41, an input module 42, an output module 43, an output terminal 44, and a functional module 45. The input terminal 41, the input module 42, the output module 43, the output terminal 44, and the functional module 45 are all installed on and electrically connected to the circuit board 20. The inductor 60 includes an inductor housing 61 and an inductor body 62. The inductor body 62 is accommodated in the inductor housing 61. The inductor body 62 is electrically connected to the circuit board 20. For example, the inductor body 62 includes a first inductor body 62a and a second inductor body 62b. The first inductor body 62a and the second inductor body 62b are accommodated in the inductor housing 61. Both the first inductor body 62a and the second inductor body 62b are electrically connected to the circuit board 20.

As shown in FIG. 3 and FIG. 4, the heat dissipation assembly 70 is mounted on the fitting piece 102. The heat dissipation assembly 70 is partially inserted into the fitting slot 1021 of the fitting piece 102, and the heat dissipation assembly 70 abuts against the fitting piece 102. The power conversion device 200 is mounted on the fitting piece 102 through the heat dissipation assembly 70, and the power conversion device 200 is installed on the carrier 100.

As shown in FIG. 1, a direct current output by the photovoltaic module 2000 is transmitted from the input terminal 41 to the first inductor body 62a through the input module 42. The first inductor body 62a is configured to boost the direct current output by the photovoltaic module 2000. A direct current obtained through boosting by the first inductor body 62a is transmitted to the power module 30. The power module 30 is configured to convert the direct current into an alternating current. The alternating current output by the power module 30 is transmitted to the second inductor body 62b. The second inductor body 62b is configured to filter the alternating current output by the power module 30. An alternating current obtained through processing by the second inductor body 62b is transmitted to the power grid 3000 through the output module 43 and the output terminal 44, so that the alternating current is supplied to the power grid 3000. The functional module 45 may be configured to supply power to the power conversion device 200. In other words, the functional module 45 is a secondary source. In some other embodiments, the functional module 45 may alternatively be configured to sample a direct current received by the power module 30.

The power module 30 is continuously turned on and turned off to convert a direct current into an alternating current, to implement a power conversion function. The capacitor 50 is configured to perform a buffer function for the power module 30, to ensure that the power module 30 can convert a direct current into an alternating current. Specifically, when the power module 30 is turned off, the direct current obtained through boosting by the first inductor body 62a can not only be transmitted to the power module 30, but also be transmitted to the capacitor 50 to charge the capacitor 50. When the power module 30 is turned on, the direct current obtained through boosting by the first inductor body 62a is not transmitted to the power module 30, and the capacitor 50 discharges to supply power to the power module 30. This ensures that, in a process of converting a direct current into an alternating current, the power module 30 can always operate stably, and the power module 30 can stably convert the direct current into an alternating current, to implement a power conversion function.

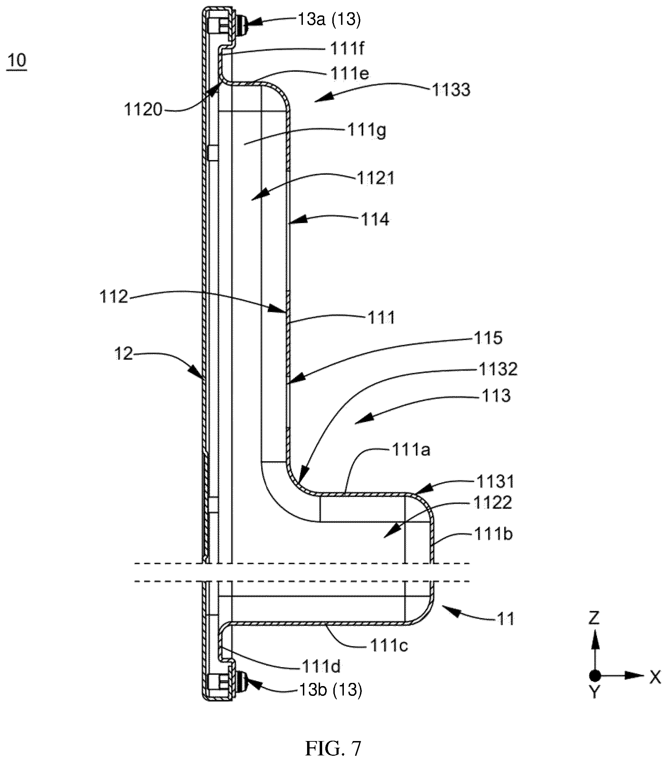

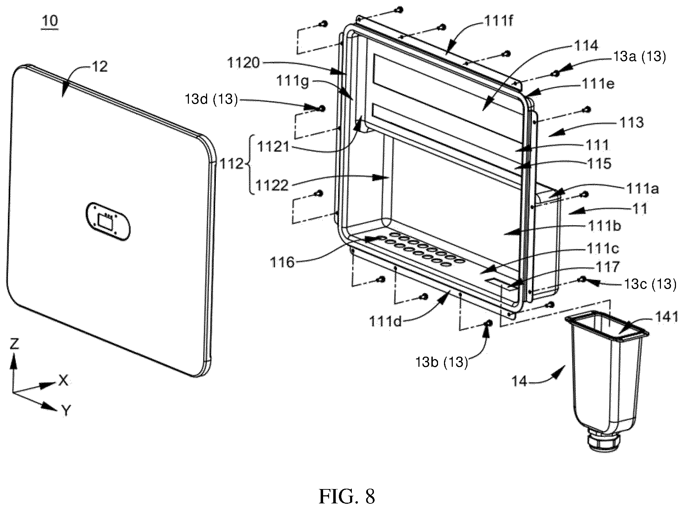

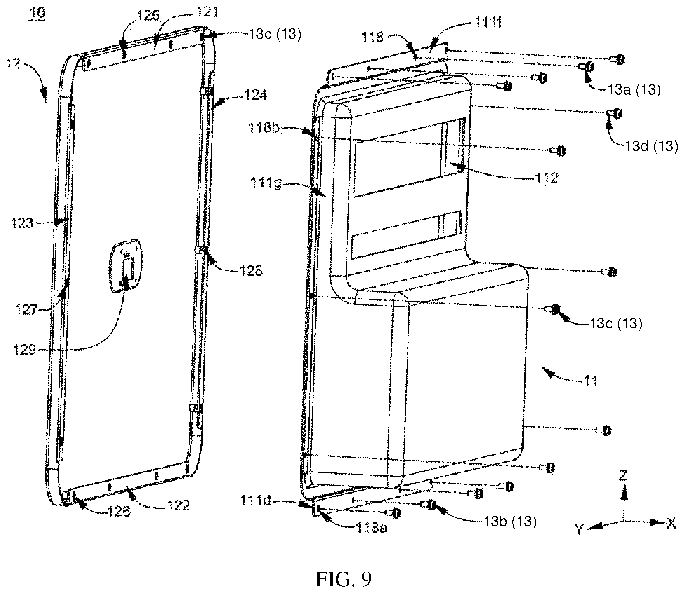

Refer to FIG. 7, FIG. 8, and FIG. 9, in conjunction with FIG. 4. FIG. 7 is a diagram of a partial structure of the housing 10, cut along the line A-A, of the power conversion device 200 shown in FIG. 4. FIG. 8 is a schematic three-dimensional exploded view of a structure of the housing 10 of the power conversion device 200 shown in FIG. 4 from another perspective. FIG. 9 is a schematic three-dimensional exploded view of a structure of the housing 10 (a third housing 14 is omitted) of the power conversion device 200 shown in FIG. 4.

As shown in FIG. 4, FIG. 7, and FIG. 8, in some embodiments, the housing 10 includes a first sub-housing 11, a second sub-housing 12, a fastener 13, and the third housing 14. Along the X-axis direction (namely, the first direction), the second sub-housing 12 is disposed on one side of the first sub-housing 11 through the fastener 13, and the second sub-housing 12 is disposed on one side of the first sub-housing 11. Along the Z-axis direction, the third housing 14 is disposed on one side of the first sub-housing 11.

As shown in FIG. 7 and FIG. 8, in some embodiments, the first sub-housing 11 includes a first cavity wall 111, a second cavity wall 111a, a third cavity wall 111b, a fourth cavity wall 111c, a fifth cavity wall 111d, a sixth cavity wall 111e, a seventh cavity wall 111f, and an eighth cavity wall 111g. The first cavity wall 111 extends along the Z-axis direction. Along the X-axis direction, the second cavity wall 111a is connected to one side of the first cavity wall 111. The second cavity wall 111a extends along the X-axis direction. Along the X-axis direction, the third cavity wall 111b is located on one side of the second cavity wall 111a and backs the first cavity wall 111. Along the Z-axis direction, the third cavity wall 111b is located on one side of the second cavity wall 111a and backs the first cavity wall 111. The third cavity wall 111b is connected to the second cavity wall 111a. The third cavity wall 111b extends along the Z-axis direction. Along the X-axis direction, the fourth cavity wall 111c is located on one side of the third cavity wall 111b and faces the second cavity wall 111a. Along the Z-axis direction, the fourth cavity wall 111c is located on one side of the third cavity wall 111b and backs the second cavity wall 111a. The fourth cavity wall 111c is connected to the third cavity wall 111b. The fourth cavity wall 111c extends along the X-axis direction.

Along the X-axis direction, the fifth cavity wall 111d is located on one side of the fourth cavity wall 111c and backs the third cavity wall 111b. Along the Z-axis direction, the fifth cavity wall 111d is located on one side of the fourth cavity wall 111c and backs the third cavity wall 111b. The fifth cavity wall 111d is connected to the fourth cavity wall 111c. The fifth cavity wall 111d extends along the Z-axis direction. Along the X-axis direction, the sixth cavity wall 111e is located on one side of the first cavity wall 111 and backs the second cavity wall 111a. Along the Z-axis direction, the sixth cavity wall 111e is located on one side of the first cavity wall 111 and backs the second cavity wall 111a. The sixth cavity wall 111e is connected to the first cavity wall 111. The sixth cavity wall 111e extends along the X-axis direction. Along the X-axis direction, the seventh cavity wall 111f is located on one side of the sixth cavity wall 111e and backs the first cavity wall 111. Along the Z-axis direction, the seventh cavity wall 111f is located on one side of the sixth cavity wall 111e and backs the first cavity wall 111. The seventh cavity wall 111f is connected to the sixth cavity wall 111e.

There are two eighth cavity walls 111g. Along the Y-axis direction, one eighth cavity wall 111g is connected to one side of the first cavity wall 111, the second cavity wall 111a, the third cavity wall 111b, the fourth cavity wall 111c, the fifth cavity wall 111d, the sixth cavity wall 111e, and the seventh cavity wall 111f, and the other eighth cavity wall 111g is connected to the other side of the first cavity wall 111, the second cavity wall 111a, the third cavity wall 111b, the fourth cavity wall 111c, the fifth cavity wall 111d, the sixth cavity wall 111e, and the seventh cavity wall 111f.

The first cavity wall 111, the second cavity wall 111a, the third cavity wall 111b, the fourth cavity wall 111c, the fifth cavity wall 111d, the sixth cavity wall 111e, the seventh cavity wall 111f, and the two eighth cavity walls 111g enclose an accommodation cavity 112. In other words, the first sub-housing 11 includes the accommodation cavity 112. The accommodation cavity 112 extends along the X-axis direction (namely, the first direction) and has an accommodation opening 1120. The first cavity wall 111, the sixth cavity wall 111e, and the two eighth cavity walls 111g enclose a first cavity 1121. The second cavity wall 111a, the third cavity wall 111b, the fourth cavity wall 111c, and the two eighth cavity walls 111g enclose a second cavity 1122. In other words, the accommodation cavity 112 includes the first cavity 1121 and the second cavity 1122. Along the Z-axis direction (namely, the third direction), the second cavity 1122 is located on one side of the first cavity 1121 and is in communication with the first cavity 1121. A size of the second cavity 1122 along the X-axis direction (that is, a depth size of the second cavity 1122) is greater than a size of the first cavity 1121 along the X-axis direction (that is, a depth size of the first cavity 1121).

The first cavity wall 111 and the second cavity wall 111a enclose an accommodation groove 113. In other words, the accommodation groove 113 is provided on one side of the first sub-housing 11. The accommodation groove 113 extends along the X-axis direction (namely, the first direction) and has a first opening 1131. Along the X-axis direction (namely, the first direction), the first opening 1131 of the accommodation groove 113 backs the first cavity 1121, and the first opening 1131 of the accommodation groove 113 backs the accommodation cavity 112. In addition, the accommodation groove 113 extends along the Y-axis direction and has a second opening 1132. To be specific, the accommodation groove 113 passes through the first sub-housing 11 along the Y-axis direction (namely, the second direction) and has the second opening 1132. For example, there are two second openings 1132. Along the Y-axis direction, the two second openings 1132 are arranged back to back. In some other embodiments, there may alternatively be one second opening 1132, or the second opening 1132 may be omitted. The accommodation groove 113 extends along the Z-axis direction and has a third opening 1133. To be specific, the accommodation groove 113 passes through the first sub-housing 11 along the Z-axis direction and has the third opening 1133. Along the Z-axis direction, the third opening 1133 backs the second cavity 1122.

It can be understood that a projection of the accommodation groove 113 along the X-axis direction overlaps a projection of the first cavity 1121 along the X-axis direction. In other words, the projection of the first cavity 1121 along the X-axis direction (namely, the first direction) overlaps the projection of the accommodation groove 113 along the X-axis direction (namely, the first direction). Along the Z-axis direction, the accommodation groove 113 is located on one side of the second cavity 1122 and faces the first cavity 1121. A projection of the accommodation groove 113 along the Z-axis direction overlaps a projection of the second cavity 1122 along the Z-axis direction. In other words, the projection of the second cavity 1122 along the Z-axis direction (namely, the third direction) overlaps the projection of the accommodation groove 113 along the Z-axis direction (namely, the third direction).

In some embodiments, the first sub-housing 11 is provided with a first through hole 114. The first through hole 114 passes through the first sub-housing 11 along the X-axis direction (namely, the first direction). Specifically, the first through hole 114 passes through the first cavity wall 111 along the X-axis direction. The first through hole 114 is in communication with the first cavity 1121 and the accommodation groove 113, and the first through hole 114 is in communication with the accommodation cavity 112 and the accommodation groove 113.

In some embodiments, the first sub-housing 11 is provided with a second through hole 115. The second through hole 115 passes through the first sub-housing 11 along the X-axis direction (namely, the first direction). Specifically, the second through hole 115 passes through the first cavity wall 111 along the X-axis direction. Along the Z-axis direction, the second through hole 115 is located on one side of the first through hole 114 and faces the second cavity 1122. The second through hole 115 is spaced away from the first through hole 114. The second through hole 115 is in communication with the first cavity 1121 and the accommodation groove 113, and the second through hole 115 is in communication with the accommodation cavity 112 and the accommodation groove 113. In some other embodiments, along the Z-axis direction, the second through hole 115 may alternatively be located on one side of the first through hole 114 and backs the second cavity 1122. The second through hole 115 is spaced away from the first through hole 114.

In some embodiments, the first sub-housing 11 is provided with a first via 116. Specifically, the fourth cavity wall 111c is provided with the first via 116. The first via 116 passes through the fourth cavity wall 111c along the Z-axis direction. The first via 116 is in communication with the second cavity 1122, and the first via 116 is in communication with the accommodation cavity 112. For example, there are a plurality of first vias 116. Specifically, there are 16 first vias 116. In some other embodiments, there may alternatively be one, two, or more first vias 116. The plurality of first vias 116 are spaced away from each other.

In some embodiments, the first sub-housing 11 is provided with a second via 117. Specifically, the fourth cavity wall 111c is provided with the second via 117. The second via 117 passes through the fourth cavity wall 111c along the Z-axis direction. The second via 117 is in communication with the second cavity 1122, and the second via 117 is in communication with the accommodation cavity 112. Along the Y-axis direction, the second via 117 is located on one side of the plurality of first vias 116 and is spaced away from the first vias 116.

As shown in FIG. 9, in some embodiments, the first sub-housing 11 is provided with a first installation hole 118. Specifically, the seventh cavity wall 111f is provided with the first installation hole 118, and the first installation hole 118 passes through the seventh cavity wall 111f along the X-axis direction. Along the Z-axis direction, the first installation hole 118 is located on one side of the accommodation cavity 112 and is spaced away from the accommodation cavity 112. For example, there are a plurality of first installation holes 118. Specifically, there are four first installation holes 118. In some other embodiments, there may alternatively be one, two, or more first installation holes 118. Along the Y-axis direction, the plurality of first installation holes 118 are sequentially arranged at spacings.

In some embodiments, the first sub-housing 11 is provided with a second installation hole 118a. Specifically, the fifth cavity wall 111d is provided with the second installation hole 118a, and the second installation hole 118a passes through the fifth cavity wall 111d along the X-axis direction. Along the Z-axis direction, the second installation hole 118a is located on one side of the accommodation cavity 112 and backs the first installation hole 118, and the second installation hole 118a is spaced away from the accommodation cavity 112. For example, there are a plurality of second installation holes 118a. Specifically, there are four second installation holes 118a. In some other embodiments, there may alternatively be one, two, or more second installation holes 118a. Along the Y-axis direction, the plurality of second installation holes 118a are sequentially arranged at spacings.

In some embodiments, the first sub-housing 11 is provided with a third installation hole 118b. Specifically, each eighth cavity wall 111g is provided with the third installation hole 118b, and the third installation hole 118b passes through the eighth cavity wall 111g along the X-axis direction. Along the Y-axis direction, the third installation hole 118b is located on one side of the accommodation cavity 112 and is spaced away from the accommodation cavity 112. For example, there are a plurality of third installation holes 118b. Specifically, there are three third installation holes 118b. In some other embodiments, there may alternatively be one, two, or more third installation holes 118b. Along the Z-axis direction, the plurality of third installation holes 118b are sequentially arranged at spacings.

As shown in FIG. 4, FIG. 6, and FIG. 8, in some embodiments, along the X-axis direction, the second sub-housing 12 is disposed on one side of the accommodation opening 1120 of the accommodation cavity 112 and backs the accommodation groove 113. The second sub-housing 12 covers the accommodation opening 1120 and closes the accommodation cavity 112. The second sub-housing 12 includes a first surface 121, a second surface 122, a third surface 123, and a fourth surface 124. An orientation of the first surface 121, an orientation of the second surface 122, an orientation of the third surface 123, and an orientation of the fourth surface 124 are the same. Along the Z-axis direction, the first surface 121 and the second surface 122 are arranged opposite to each other at a spacing, and the third surface 123 and the fourth surface 124 are located between the first surface 121 and the second surface 122, and are both spaced away from the first surface 121 and the second surface 122. Along the Y-axis direction, the third surface 123 and the fourth surface 124 are located on two sides of the first surface 121 and the second surface 122, and are both spaced away from the first surface 121 and the second surface 122. The first surface 121, the second surface 122, the third surface 123, and the fourth surface 124 all face the first sub-housing 11. The first surface 121 is stacked on the seventh cavity wall 111f. The second surface 122 is stacked on the fifth cavity wall 111d. The third surface 123 and the fourth surface 124 are respectively stacked on the two eighth cavity walls 111g.

The second sub-housing 12 is provided with a first fitting-installation hole 125. The first fitting-installation hole 125 extends from the first surface 121 along the X-axis direction. For example, there are a plurality of first fitting-installation holes 125. A quantity of first fitting-installation holes 125 is equal to a quantity of first installation holes 118. The plurality of first fitting-installation holes 125 are in communication with the plurality of first installation holes 118 in a one-to-one correspondence.

The second sub-housing 12 is provided with a second fitting-installation hole 126. The second fitting-installation hole 126 extends from the second surface 122 along the X-axis direction. For example, there are a plurality of second fitting-installation holes 126. A quantity of second fitting-installation holes 126 is equal to a quantity of second installation holes 118a. The plurality of second fitting-installation holes 126 are in communication with the plurality of second installation holes 118a in a one-to-one correspondence.

The second sub-housing 12 is provided with a third fitting-installation hole 127. The third fitting-installation hole 127 extends from the third surface 123 along the X-axis direction. The second sub-housing 12 is provided with a fourth fitting-installation hole 128. The fourth fitting-installation hole 128 extends from the fourth surface 124 along the X-axis direction. For example, there are a plurality of third fitting-installation holes 127, and there are a plurality of fourth fitting-installation holes 128. A quantity of third fitting-installation holes 127 is equal to a quantity of third installation holes 118b of one eighth cavity wall 111g. The plurality of third fitting-installation holes 127 are in communication with a plurality of third installation holes 118b of the eighth cavity wall 111g in a one-to-one correspondence. A quantity of fourth fitting-installation holes 128 is equal to a quantity of third installation holes 118b of the other eighth cavity wall 111g. The plurality of fourth fitting-installation holes 128 are in communication with a plurality of third installation holes 118b of the eighth cavity wall 111g in a one-to-one correspondence.

In some embodiments, the second sub-housing 12 is provided with a mounting hole 129. The mounting hole 129 passes through the second sub-housing 12 along the X-axis direction. The mounting hole 129 is spaced away from the first fitting-installation hole 125, the second fitting-installation hole 126, the third fitting-installation hole 127, and the fourth fitting-installation hole 128. The second sub-housing 12 may be mounted on an external component through the mounting hole 129. To be specific, the housing 10 may be mounted on the external component through the mounting hole 129, and the power conversion device 200 may be mounted on the external component through the mounting hole 129.

In some embodiments, there are a plurality of fasteners 13. Specifically, there are 14 fasteners 13. The 14 fasteners 13 are divided into four first fasteners 13a, four second fasteners 13b, three third fasteners 13c, and three fourth fasteners 13d. The four first fasteners 13a pass through the plurality of first installation holes 118 and the plurality of first fitting-installation holes 125 in a one-to-one correspondence. The four second fasteners 13b pass through the plurality of second installation holes 118a and the plurality of second fitting-installation holes 126 in a one-to-one correspondence. The three third fasteners 13c pass through a plurality of third installation holes 118b of one eighth cavity wall 111g and the plurality of third fitting-installation holes 127 in a one-to-one correspondence. The three fourth fasteners 13d pass through a plurality of third installation holes 118b of the other eighth cavity wall 111g and the plurality of fourth fitting-installation holes 128 in a one-to-one correspondence. In this way, with the plurality of fasteners 13, the second sub-housing 12 is disposed on one side of the accommodation opening 1120 of the accommodation cavity 112 and backs the accommodation groove 113, and the second sub-housing 12 covers the accommodation opening 1120 and closes the accommodation cavity 112.

As shown in FIG. 4 and FIG. 8, in some embodiments, along the Z-axis direction, in a manner including but not limited to welding, bonding, or screwing, the third housing 14 is disposed on one side of the fourth cavity wall 111c and backs the accommodation cavity 112, and the third housing 14 is disposed on one side of the first sub-housing 11 and backs the accommodation cavity 112. The third housing 14 is provided with a groove 141. The groove 141 extends along the Z-axis direction and has an opening, and the opening of the groove 141 is in communication with the second via 117.

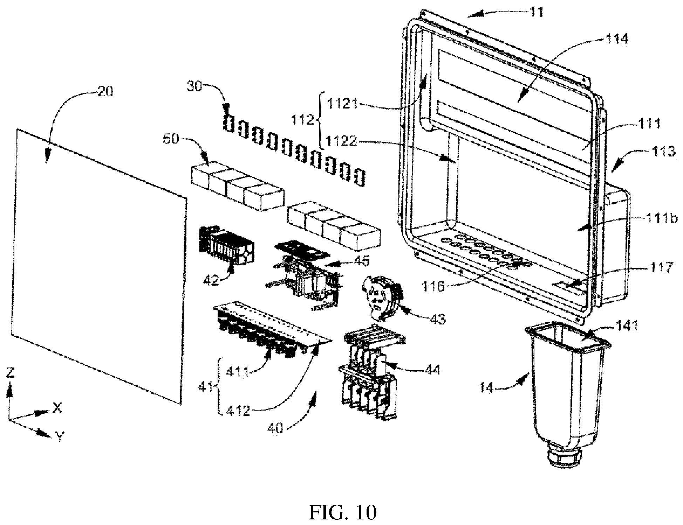

Refer to FIG. 10, in conjunction with FIG. 1, FIG. 5, and FIG. 6. FIG. 10 is a schematic three-dimensional exploded view of a structure of the power conversion device 200 shown in FIG. 4 from another perspective, where the second sub-housing 12, the fastener 13, the inductor 60, and the heat dissipation assembly 70 are omitted.

As shown in FIG. 5 and FIG. 10, in some embodiments, the circuit board 20 is accommodated in the accommodation cavity 112. Along the X-axis direction, the circuit board 20 is located between the first sub-housing 11 and the second sub-housing 12, and is spaced away from the first sub-housing 11 and the second sub-housing 12. Specifically, the circuit board 20 is located between the first cavity wall 111 and the second sub-housing 12, and the circuit board 20 is spaced away from the first cavity wall 111 and the second sub-housing 12. Along the X-axis direction, the circuit board 20 is located on one side of the plurality of first vias 116 and backs the third cavity wall 111b, and the circuit board 20 is located on one side of the second via 117 and backs the third cavity wall 111b.

As shown in FIG. 5, FIG. 6, and FIG. 10, in some embodiments, along the X-axis direction, the power module 30 is installed on one side of the circuit board 20 and faces the first sub-housing 11. Specifically, in a manner including but not limited to plug-connection or welding, the power module 30 is fastened to one side of the circuit board 20 and faces the first sub-housing 11. In other words, along the X-axis direction (namely, the first direction), the circuit board 20 is installed on one side of the power module 30 and backs the first sub-housing 11. Along the X-axis direction, the power module 30 is spaced away from the first sub-housing 11, and the power module 30 is spaced away from the first cavity wall 111. The power module 30 is accommodated in the accommodation cavity 112. Specifically, the power module 30 is accommodated in the first cavity 1121. A projection of the power module 30 along the X-axis direction overlaps a projection of the first through hole 114 along the X-axis direction. For example, there are a plurality of power modules 30. Specifically, there are 10 power modules 30. In some other embodiments, there may alternatively be one, two, or more power modules 30. Along the Y-axis direction, the plurality of power modules 30 are sequentially arranged at spacings.

In some embodiments, along the X-axis direction, the auxiliary module 40 is installed on one side of the circuit board 20 and faces the power module 30. Along the Z-axis direction, the auxiliary module 40 is located on one side of the power module 30 and is spaced away from the power module 30. The auxiliary module 40 is accommodated in the accommodation cavity 112. Specifically, the auxiliary module 40 is accommodated in the second cavity 1122. A projection of the auxiliary module 40 along the Z-axis direction (namely, the third direction) overlaps the projection of the accommodation groove 113 along the Z-axis direction (namely, the third direction).

This ensures that both the power module 30 and the auxiliary module 40 can be accommodated in the accommodation cavity 112. On this basis, the depth size of the first cavity 1121 (to be specific, the size of the first cavity 1121 along the X-axis direction) adapts to a size of the power module 30 along the first direction (namely, the X-axis direction), and the depth size of the second cavity 1122 (to be specific, the size of the second cavity 1122 along the X-axis direction) adapts to a size of the auxiliary module 40 along the first direction (namely, the X-axis direction). The design in which the power module 30 is accommodated in the first cavity 1121 and the auxiliary module 40 is accommodated in the second cavity 1122 can ensure that the projection of the auxiliary module 40 along the Z-axis direction (namely, the third direction) overlaps the projection of the accommodation groove 113 along the Z-axis direction (namely, the third direction). This helps improve space utilization of the accommodation cavity 112, helps reduce a size of the housing 10 along the X-axis direction (namely, the first direction), helps improve space utilization of the housing 10, facilitates a miniaturization design for the housing 10, facilitates a miniaturization design for the power conversion device 200, and helps improve power density of the power conversion device 200.

It can be understood that the design in which the projection of the auxiliary module 40 along the Z-axis direction (namely, the third direction) overlaps the projection of the accommodation groove 113 along the Z-axis direction (namely, the third direction) helps improve space utilization of the accommodation cavity 112, helps reduce the size of the housing 10 along the X-axis direction (namely, the first direction), helps improve space utilization of the housing 10, facilitates a miniaturization design for the housing 10, facilitates a miniaturization design for the power conversion device 200, and helps improve power density of the power conversion device 200.

In some embodiments, along the X-axis direction, the input terminal 41 is installed on one side of the circuit board 20 and faces the power module 30. Along the Z-axis direction, the input terminal 41 is located on one side of the power module 30 and is spaced away from the power module 30. The input terminal 41 includes a connection portion 411 and a terminal portion 412. Along the Z-axis direction, the terminal portion 412 is fastened to one side of the connection portion 411. For example, there are a plurality of terminal portions 412. Specifically, there are 16 terminal portions 412. In some other embodiments, there may alternatively be one, two, or more terminal portions 412. The connection portion 411 is installed on the circuit board 20. Along the Z-axis direction, the connection portion 411 is located on one side of the power module 30 and is spaced away from the power module 30. The plurality of terminal portions 412 back the power module 30.

The connection portion 411 is accommodated in the second cavity 1122. The plurality of terminal portions 412 pass through the plurality of first vias 116 in a one-to-one correspondence. The plurality of terminal portions 412 are partially accommodated in the second cavity 1122 and partially exposed out of the second cavity 1122. The input terminal 41 receives, through the terminal portion 412, a direct current output by the photovoltaic module 2000 (as shown in FIG. 1). Both a projection of the connection portion 411 along the Z-axis direction and projections of the plurality of terminal portions 412 along the Z-axis direction overlap the projection of the accommodation groove 113 along the Z-axis direction. In other words, a projection of the input terminal 41 along the Z-axis direction overlaps the projection of the accommodation groove 113 along the Z-axis direction.

In some embodiments, along the X-axis direction, the input module 42 is installed on one side of the circuit board 20 and faces the power module 30. Along the Z-axis direction, the input module 42 is located between the power module 30 and the input terminal 41, and is spaced away from the power module 30 and the input terminal 41. The input module 42 is accommodated in the second cavity 1122. Along the X-axis direction, the input module 42 is spaced away from the first sub-housing 11, and the input module 42 is spaced away from the third cavity wall 111b. A projection of the input module 42 along the Z-axis direction overlaps the projection of the accommodation groove 113 along the Z-axis direction.

In some embodiments, along the X-axis direction, the output module 43 is installed on one side of the circuit board 20 and faces the power module 30. Along the Z-axis direction, the output module 43 is located between the power module 30 and the input terminal 41, and is spaced away from the power module 30 and the input terminal 41. Along the Y-axis direction, the output module 43 is located on one side of the input terminal 41 and the input module 42, and is spaced away from the input terminal 41 and the input module 42. The output module 43 is accommodated in the second cavity 1122. Along the X-axis direction, the output module 43 is spaced away from the first sub-housing 11, and the output module 43 is spaced away from the third cavity wall 111b. A projection of the output module 43 along the Z-axis direction overlaps the projection of the accommodation groove 113 along the Z-axis direction.

In some embodiments, along the X-axis direction, the output terminal 44 is installed on one side of the circuit board 20 and faces the power module 30. Along the Z-axis direction, the output terminal 44 is located on one side of the output module 43 and backs the power module 30, and the output terminal 44 is spaced away from the output module 43. Along the Y-axis direction, the output terminal 44 is located on one side of the input terminal 41 and faces the output module 43, and the output terminal 44 is spaced away from the input terminal 41. The output terminal 44 passes through the second via 117. The output terminal 44 is partially accommodated in the second cavity 1122 and partially accommodated in the groove 141 of the third housing 14. Along the X-axis direction, the output terminal 44 is spaced away from the first sub-housing 11, and the output terminal 44 is spaced away from the third cavity wall 111b. The output terminal 44 is spaced away from the third housing 14, and the output terminal 44 is spaced away from a groove wall of the groove 141. A projection of the output terminal 44 along the Z-axis direction overlaps the projection of the accommodation groove 113 along the Z-axis direction.

In some embodiments, along the X-axis direction, the functional module 45 is installed on one side of the circuit board 20 and faces the power module 30. Along the Z-axis direction, the functional module 45 is located between the power module 30 and the input terminal 41, and is spaced away from the power module 30 and the input terminal 41. Along the Y-axis direction, the functional module 45 is located between the input module 42 and the output module 43, and is spaced away from the input module 42 and the output module 43. The functional module 45 is accommodated in the second cavity 1122. Along the X-axis direction, the functional module 45 is spaced away from the first sub-housing 11, and the functional module 45 is spaced away from the third cavity wall 111b. A projection of the functional module 45 along the Z-axis direction overlaps the projection of the accommodation groove 113 along the Z-axis direction.

In some embodiments, along the X-axis direction (namely, the first direction), the capacitor 50 is installed on one side of the circuit board 20 and faces the power module 30. Along the Z-axis direction, the capacitor 50 is located between the power module 30 and the auxiliary module 40, and is spaced away from the power module 30 and the auxiliary module 40. The capacitor 50 is spaced away from the auxiliary module 40. For example, there are a plurality of capacitors 50. Specifically, there are eight capacitors 50. In some other embodiments, there may alternatively be one, two, or more capacitors 50. Along the Y-axis direction, the plurality of capacitors 50 are sequentially arranged at spacings. The plurality of capacitors 50 are accommodated in the accommodation cavity 112. The capacitor 50 is accommodated in the accommodation cavity 112, and the capacitor 50 is accommodated in the second cavity 1122. Along the X-axis direction, the capacitor 50 is spaced away from the first sub-housing 11, and the capacitor 50 is spaced away from the third cavity wall 111b. A projection of the capacitor 50 along the Z-axis direction overlaps the projection of the accommodation groove 113 along the Z-axis direction.

This ensures that the capacitor 50 can be accommodated in the accommodation cavity 112. On this basis, the depth size of the second cavity 1122 (to be specific, the size of the second cavity 1122 along the X-axis direction) adapts to a size of the capacitor 50 along the first direction (namely, the X-axis direction). The design in which the capacitor 50 is accommodated in the second cavity 1122 can ensure that the projection of the capacitor 50 along the Z-axis direction (namely, the third direction) overlaps the projection of the accommodation groove 113 along the Z-axis direction (namely, the third direction). The design in which the projection of the capacitor 50 along the Z-axis direction (namely, the third direction) overlaps the projection of the accommodation groove 113 along the Z-axis direction (namely, the third direction) helps improve space utilization of the accommodation cavity 112, helps reduce the size of the housing 10 along the X-axis direction (namely, the first direction), helps improve space utilization of the housing 10, facilitates a miniaturization design for the housing 10, facilitates a miniaturization design for the power conversion device 200, and helps improve power density of the power conversion device 200.

It can be understood that a shape of the accommodation cavity 112 adapts to a shape of the circuit board 20, a shape of the power module 30, a shape of the auxiliary module 40, and a shape of the capacitor 50, and the accommodation cavity 112 is filled with the circuit board 20, the power module 30, the auxiliary module 40, and the capacitor 50 at high density. This greatly improves space utilization of the accommodation cavity 112, helps improve space utilization of the housing 10, facilitates a miniaturization design for the housing 10, facilitates a miniaturization design for the power conversion device 200, and helps improve power density of the power conversion device 200.

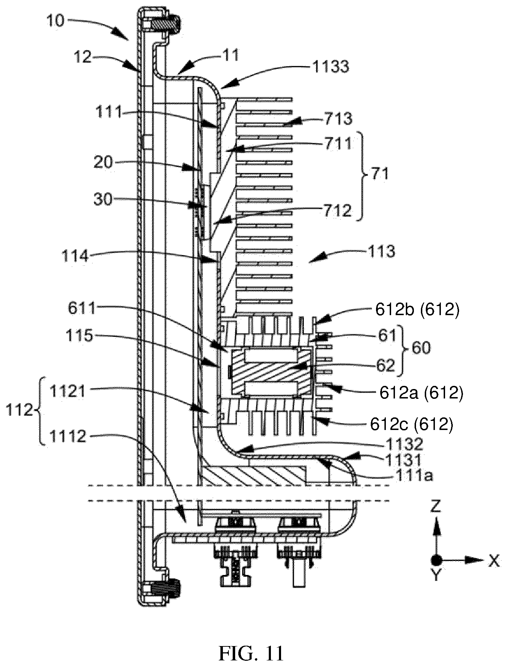

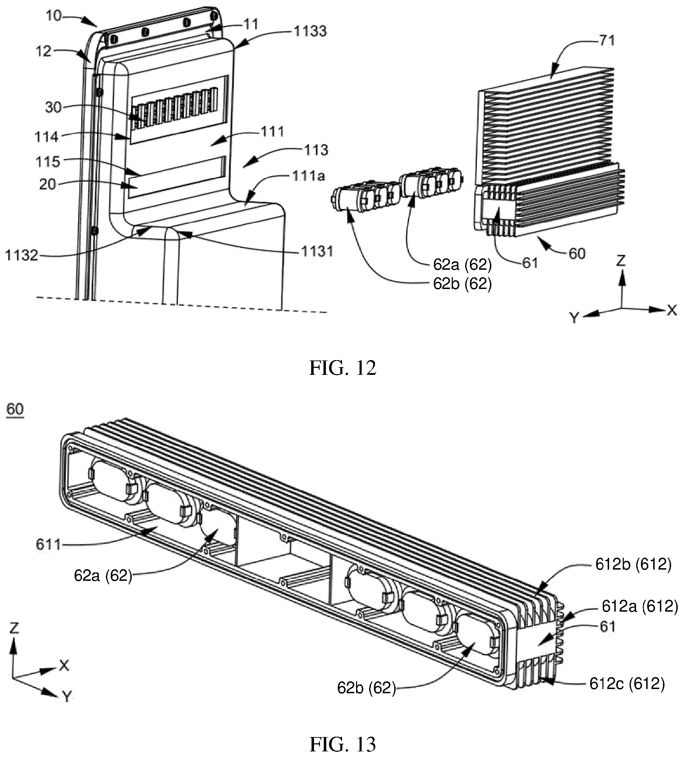

Refer to FIG. 11, FIG. 12, and FIG. 13. FIG. 11 is a diagram of a partial structure of the power conversion device 200 (an air director 72, a mounting kit 73, and a fan 74 are omitted) shown in FIG. 4 that is cut along a line B-B. FIG. 12 is a schematic three-dimensional exploded view of a partial structure of the power conversion device 200 shown in FIG. 11. FIG. 13 is a three-dimensional diagram of a structure of an assembled inductor 60 of the power conversion device 200 shown in FIG. 12 from another perspective.

In some embodiments, the inductor 60 is accommodated in the accommodation groove 113. A projection of the inductor 60 along the X-axis direction overlaps a projection of the second through hole 115 along the X-axis direction. The inductor 60 is electrically connected to the circuit board 20 through the second through hole 115, and the inductor 60 is electrically connected to the circuit board 20. The design in which the inductor 60 is accommodated in the accommodation groove 113 not only ensures that heat generated by the inductor 60 during operation can be directly transferred out of the housing 10 to quickly dissipate heat for the inductor 60, but also greatly improves space utilization of the housing 10. This helps reduce a size of the power conversion device 200 along the X-axis direction (namely, the first direction), and facilitates a miniaturization design for the power conversion device 200.

In some embodiments, in a manner including but not limited to welding or bonding, the inductor housing 61 is fastened and stacked on one side of the first cavity wall 111 and backs the first cavity 1121. Along the X-axis direction, the inductor housing 61 is fastened and stacked on one side of the first sub-housing 11 and backs the accommodation cavity 112. The inductor housing 61 is accommodated in the accommodation groove 113. A projection of the inductor housing 61 along the X-axis direction covers the projection of the second through hole 115 along the X-axis direction.

An installation slot 611 is provided on one side of the inductor housing 61. The installation slot 611 extends along the X-axis direction (namely, the first direction) and has an opening. Along the X-axis direction (namely, the first direction), the opening of the installation slot 611 faces the first cavity 1121, and the opening of the installation slot 611 faces the accommodation cavity 112. The opening of the installation slot 611 is in communication with the second through hole 115, and the installation slot 611 is in communication with the second through hole 115. The installation slot 611 is in communication with the first cavity 1121, and the installation slot 611 is in communication with the accommodation cavity 112. For example, there are a plurality of installation slots 611. Specifically, there are two installation slots 611. In some other embodiments, there may alternatively be one, three, or more installation slots 611. Along the Y-axis direction, the plurality of installation slots 611 are spaced away from each other.

In some embodiments, the inductor housing 61 is provided with a thermally conductive fin 612. The thermally conductive fin 612 is located outside the installation slot 611. For example, the thermally conductive fin 612 includes a first thermally conductive fin 612a, a second thermally conductive fin 612b, and a third thermally conductive fin 612c. Along the X-axis direction, the first thermally conductive fin 612a is fastened and stacked on one side of the inductor housing 61 and backs the installation slot 611. Along the Y-axis direction, the second thermally conductive fin 612b is fastened and stacked on one side of the inductor housing 61 and backs the installation slot 611. Along the Y-axis direction, the third thermally conductive fin 612c is fastened and stacked on one side of the inductor housing 61 and backs the second thermally conductive fin 612b. In some other embodiments, the inductor housing 61 may alternatively be provided with only the first thermally conductive fin 612a, the second thermally conductive fin 612b, or the third thermally conductive fin 612c.

In some embodiments, there are a plurality of first inductor bodies 62a of the inductor 60. Specifically, there are three first inductor bodies 62a. In some other embodiments, there may alternatively be one, two, or more first inductor bodies 62a. There are a plurality of second inductor bodies 62b of the inductor 60. Specifically, there are three second inductor bodies 62b. In some other embodiments, there may alternatively be one, two, or more second inductor bodies 62b. The plurality of first inductor bodies 62a are accommodated in one installation slot 611, and the plurality of first inductor bodies 62a are sequentially arranged at spacings along the Y-axis direction. The plurality of second inductor bodies 62b are accommodated in another installation slot 611, and the plurality of second inductor bodies 62b are sequentially arranged at spacings along the Y-axis direction.

It can be understood that the inductor body 62 of the inductor 60 is accommodated in the installation slot 611. A projection of the inductor body 62 along the X-axis direction overlaps the projection of the second through hole 115 along the X-axis direction. The inductor body 62 is electrically connected to the circuit board 20 through the second through hole 115, and the inductor body 62 is electrically connected to the circuit board 20. For example, the power conversion device 200 includes a connector (including but not limited to a copper clip and a wire). The connector passes through the second through hole 115. The connector is connected to the inductor body 62 and the circuit board 20, and the connector is disposed between the inductor 60 and the circuit board 20. Through the connector, the inductor body 62 is electrically connected to the circuit board 20, and the inductor 60 is electrically connected to the circuit board 20. For another example, the inductor body 62 may pass through the second through hole 115, the inductor body 62 is plug-connected to the circuit board 20, and the inductor body 62 is electrically connected to the circuit board 20. In other words, the inductor 60 passes through the second through hole 115, the inductor 60 is plug-connected to the circuit board 20, and the inductor 60 is electrically connected to the circuit board 20.

The design of the second through hole 115 facilitates an electrical connection between the inductor body 62 (namely, the inductor 60) and the circuit board 20 in a manner including but not limited to wiring or plug-connection. This helps reduce difficulty in the electrical connection between the inductor body 62 (namely, the inductor 60) and the circuit board 20, and helps reduce processing costs of the power conversion device 200.

Heat generated by the inductor body 62 during operation is transferred to an external environment through the inductor housing 61. The design in which the inductor housing 61 is provided with the thermally conductive fin 612 helps increase a heat dissipation area in which heat generated by the inductor body 62 during operation is transferred to the outside through the inductor housing 61, helps improve efficiency of transferring heat generated by the inductor body 62 during operation to the outside through the inductor housing 61, helps improve heat dissipation efficiency for the inductor body 62, and helps improve heat dissipation efficiency for the inductor 60.

It can be understood that the design in which the accommodation groove 113 extends along the X-axis direction (namely, the first direction) and has the first opening 1131 and the accommodation groove 113 passes through the first sub-housing 11 along the Y-axis direction (namely, the second direction) and has the second opening 1132 ensures that the inductor 60 can be exposed out of the housing 10 through the first opening 1131 and the second opening 1132. This helps increase a contact area between the inductor 60 and an external environment of the housing 10, helps improve efficiency of transferring heat generated by the inductor 60 during operation out of the housing 10, and helps improve heat dissipation efficiency for the inductor 60.

The design in which the accommodation groove 113 passes through the first sub-housing 11 along the Z-axis direction (namely, the third direction) and has the third opening 1133 ensures that the inductor 60 can be exposed out of the housing 10 through the third opening 1133. This helps increase a contact area between the inductor 60 and the external environment of the housing 10, helps improve efficiency of transferring heat generated by the inductor 60 during operation out of the housing 10, and helps improve heat dissipation efficiency for the inductor 60.

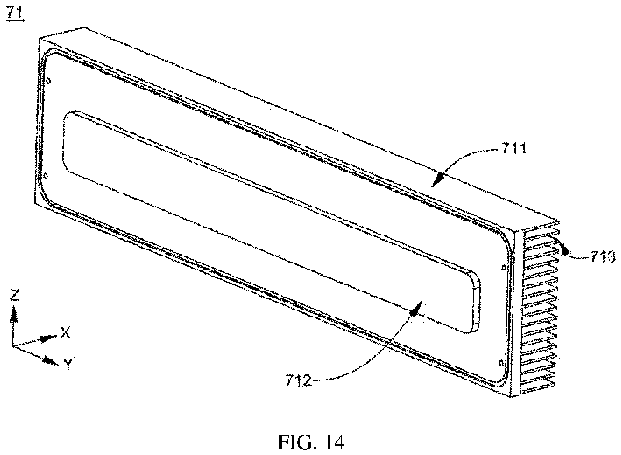

Refer to FIG. 14, in conjunction with FIG. 5, FIG. 6, FIG. 11, and FIG. 12. FIG. 14 is a three-dimensional diagram of a structure of a heat sink 71 of the power conversion device 200 shown in FIG. 12 from another perspective.

As shown in FIG. 5, FIG. 6, and FIG. 11, the heat dissipation assembly 70 includes the heat sink 71, the air director 72, the mounting kit 73, and the fan 74. In other words, the power conversion device 200 includes the heat sink 71, the air director 72, the mounting kit 73, and the fan 74. The heat sink 71 is accommodated in the accommodation groove 113. The heat sink 71 is spaced away from the inductor 60. The heat sink 71 is connected to the power module 30 in a thermally conductive manner. Along the X-axis direction, the air director 72 is disposed on one side of the heat sink 71 and backs the housing 10. Along the X-axis direction, the mounting kit 73 is disposed on one side of the air director 72 and backs the housing 10. In addition, along the X-axis direction, the mounting kit 73 is disposed on one side of the housing 10 and backs the accommodation cavity 112. The air director 72 is disposed on one side of the heat sink 71 through the mounting kit 73 and backs the housing 10. Along the X-axis direction, the fan 74 is disposed between the air director 72 and the heat sink 71.

As shown in FIG. 11, FIG. 12, and FIG. 14, along the X-axis direction, the heat sink 71 is fastened and stacked on one side of the first cavity wall 111 and backs the first cavity 1121, and the heat sink 71 is fastened and stacked on one side of the first sub-housing 11 and backs the accommodation cavity 112. In other words, along the X-axis direction (namely, the first direction), the heat sink 71 is disposed on one side of the first sub-housing 11 and backs the second sub-housing 12. Along the Z-axis direction, the heat sink 71 is located on one side of the inductor 60 and backs the second cavity 1122, and the heat sink 71 is spaced away from the inductor 60. The heat sink 71 is partially accommodated in the accommodation groove 113. The heat sink 71 is partially inserted into the first cavity 1121 through the first through hole 114, and the heat sink 71 is partially inserted into the accommodation cavity 112 through the first through hole 114. In other words, the heat sink 71 is exposed to the accommodation cavity 112 through the first through hole 114. The heat sink 71 is in contact with the power module 30. Specifically, the heat sink 71 is fastened and stacked on the power module 30. In this way, the heat sink 71 is connected to the power module 30 in a thermally conductive manner. Heat generated by the power module 30 during operation may be transferred out of the housing 10 through the heat sink 71. In some other embodiments, the first through hole 114 may alternatively be omitted, the power module 30 and the heat sink 71 are fastened and stacked on two opposite sides of the first cavity wall 111, and the power module 30 may alternatively be connected to the heat sink 71 in a thermally conductive manner through the first sub-housing 11.

In the power conversion device 200 provided in this embodiment of this application, heat generated by the power module 30 during operation is transferred out of the housing 10 through the heat sink 71, to quickly dissipate heat for the power module 30. Compared with an existing power conversion device 200, in the power conversion device 200 provided in this application, because the heat sink 71 is accommodated in the accommodation groove 113, space utilization of the housing 10 is greatly improved while heat dissipation efficiency for the power module 30 is ensured. This helps reduce the size of the power conversion device 200 along the X-axis direction (namely, the first direction), and facilitates a miniaturization design for the power conversion device 200.

The design in which the heat sink 71 is in contact with the power module 30 helps improve efficiency of transferring heat generated by the power module 30 during operation to the heat sink 71, helps improve efficiency of transferring heat generated by the power module 30 during operation out of the housing 10 through the heat sink 71, and helps improve heat dissipation efficiency for the power module 30.

In some embodiments, the heat sink 71 includes a first heat dissipation portion 711 and a second heat dissipation portion 712. Along the X-axis direction, the second heat dissipation portion 712 is disposed on one side of the first heat dissipation portion 711. Specifically, the second heat dissipation portion 712 is fastened and stacked on one side of the first heat dissipation portion 711. The first heat dissipation portion 711 is fastened and stacked on one side of the first cavity wall 111 and backs the first cavity 1121, and the first heat dissipation portion 711 is disposed on one side of the first sub-housing 11 and backs the accommodation cavity 112. The second heat dissipation portion 712 passes through the first through hole 114, the second heat dissipation portion 712 is partially accommodated in the first cavity 1121, and the second heat dissipation portion 712 is partially accommodated in the accommodation cavity 112. The second heat dissipation portion 712 is exposed to the accommodation cavity 112 through the first through hole 114. The second heat dissipation portion 712 is in contact with the power module 30. Specifically, the second heat dissipation portion 712 is fastened and stacked on the power module 30.

In some embodiments, the heat sink 71 is provided with a heat dissipation fin 713. Specifically, the heat dissipation fin 713 is disposed on one side of the first heat dissipation portion 711. Along the X-axis direction, the heat dissipation fin 713 backs the second heat dissipation portion 712, and the heat dissipation fin 713 backs the first sub-housing 11. For example, there are a plurality of heat dissipation fins 713. Specifically, there are 18 heat dissipation fins 713. In some other embodiments, there may alternatively be one, two, or more heat dissipation fins 713. Along the Z-axis direction, the plurality of heat dissipation fins 713 are sequentially arranged at spacings.

The design in which the heat sink 71 is provided with the heat dissipation fin 713 helps increase a heat dissipation area in which heat generated by the power module 30 during operation is transferred to the outside through the heat sink 71, helps improve efficiency of transferring heat generated by the power module 30 during operation to the outside through the heat sink 71, and helps improve heat dissipation efficiency for the power module 30.

It can be understood that the design in which the accommodation groove 113 extends along the X-axis direction (namely, the first direction) and has the first opening 1131 and the accommodation groove 113 passes through the first sub-housing 11 along the Y-axis direction (namely, the second direction) and has the second opening 1132 ensures that the heat sink 71 can be exposed out of the housing 10 through the first opening 1131 and the second opening 1132. This helps increase a contact area between the heat sink 71 and the external environment of the housing 10, helps improve efficiency of transferring heat generated by the power module 30 during operation out of the housing 10 through the heat sink 71, and helps improve heat dissipation efficiency for the power module 30.

The design in which the accommodation groove 113 passes through the first sub-housing 11 along the Z-axis direction (namely, the third direction) and has the third opening 1133 ensures that the heat sink 71 can be exposed out of the housing 10 through the third opening 1133. This helps increase a contact area between the heat sink 71 and the external environment of the housing 10, helps improve efficiency of transferring heat generated by the power module 30 during operation out of the housing 10 through the heat sink 71, and helps improve heat dissipation efficiency for the power module 30.

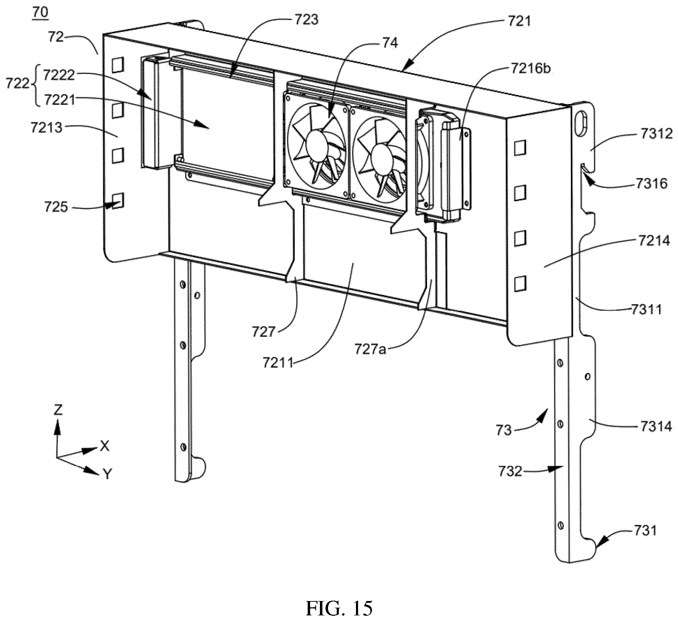

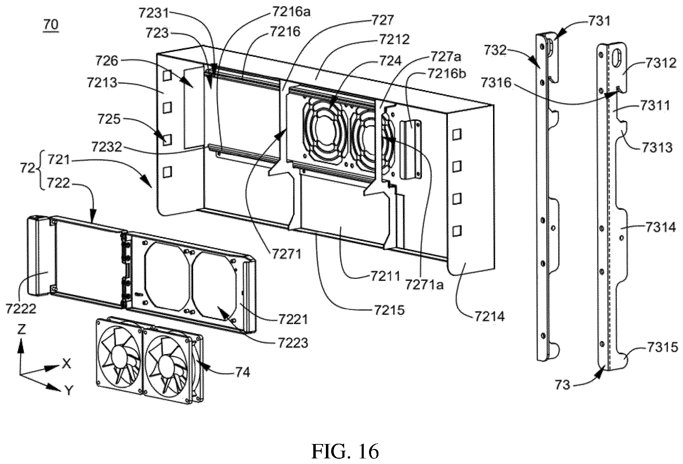

Refer to FIG. 15 and FIG. 16, in conjunction with FIG. 3, FIG. 4, FIG. 5, and FIG. 6. FIG. 15 is a three-dimensional diagram of a structure of the heat dissipation assembly 70 (the heat sink 71 is omitted) of the power conversion device 200 shown in FIG. 4 from another perspective. FIG. 16 is a schematic three-dimensional exploded view of a structure of the heat dissipation assembly 70 shown in FIG. 15.

As shown in FIG. 5, FIG. 6, and FIG. 15, in some embodiments, the air director 72 is disposed on one side of the heat sink 71 and backs the first sub-housing 11. In addition, the air director 72 is disposed on one side of the inductor 60 and backs the first sub-housing 11. The air director 72 covers the outside of the heat sink 71 and the outside of the inductor 60. The air director 72 covers the accommodation groove 113.

As shown in FIG. 5, FIG. 6, and FIG. 16, in some embodiments, the air director 72 includes a stationary portion 721 and a slidable portion 722. The slidable portion 722 is slidably connected to the stationary portion 721 along the Y-axis direction (namely, the second direction). Along the X-axis direction (namely, the first direction), the stationary portion 721 is disposed on one side of the heat sink 71 and backs the first sub-housing 11. In addition, along the X-axis direction (namely, the first direction), the stationary portion 721 is disposed on one side of the inductor 60 and backs the first sub-housing 11. The stationary portion 721 covers the outside of the heat sink 71 and the outside of the inductor 60. Along the X-axis direction, the slidable portion 722 is located between the heat sink 71 and the stationary portion 721, and the slidable portion 722 is spaced away from the heat sink 71. In addition, along the Z-axis direction, the slidable portion 722 is located on one side of the inductor 60 and faces the heat sink 71, and the slidable portion 722 is spaced away from the inductor 60. The stationary portion 721 and the slidable portion 722 jointly cover the accommodation groove 113.

In some embodiments, the stationary portion 721 includes a first sub-portion 7211, a second sub-portion 7212, a third sub-portion 7213, a fourth sub-portion 7214, and a fifth sub-portion 7215. The first sub-portion 7211 extends along the Y-axis direction. Along the Z-axis direction, the second sub-portion 7212 is connected to one side of the first sub-portion 7211. The second sub-portion 7212 extends along the X-axis direction. Along the X-axis direction, the third sub-portion 7213 and the fourth sub-portion 7214 are located on one side of the first sub-portion 7211, and are both connected to the first sub-portion 7211. Along the Z-axis direction, the third sub-portion 7213 and the fourth sub-portion 7214 are located on one side of the second sub-portion 7212 and face the first sub-portion 7211, and both the third sub-portion 7213 and the fourth sub-portion 7214 are connected to the second sub-portion 7212. Along the Y-axis direction, the third sub-portion 7213 and the fourth sub-portion 7214 are arranged opposite to each other at a spacing. Both the third sub-portion 7213 and the fourth sub-portion 7214 extend along the Z-axis direction. Along the Z-axis direction, the fifth sub-portion 7215 is located on one side of the first sub-portion 7211 and backs the second sub-portion 7212, and the fifth sub-portion 7215 is connected to the first sub-portion 7211. Along the Y-axis direction, the fifth sub-portion 7215 is located between the third sub-portion 7213 and the fourth sub-portion 7214, and is connected to the third sub-portion 7213 and the fourth sub-portion 7214.

Along the X-axis direction, the first sub-portion 7211 is located on one side of the heat sink 71 and backs the first cavity wall 111, the first sub-portion 7211 is located on one side of the heat sink 71 and backs the first sub-housing 11, and the first sub-portion 7211 is spaced away from the heat sink 71. In addition, along the X-axis direction, the first sub-portion 7211 is located on one side of the inductor 60 and backs the first cavity wall 111, the first sub-portion 7211 is located on one side of the inductor 60 and backs the first sub-housing 11, and the first sub-portion 7211 is spaced away from the inductor 60. A projection of the first sub-portion 7211 along the X-axis direction overlaps a projection of the first opening 1131 of the accommodation groove 113 along the X-axis direction. The first sub-portion 7211 covers the first opening 1131 of the accommodation groove 113.

Along the Z-axis direction, the second sub-portion 7212 is located on one side of the heat sink 71 and backs the inductor 60, and the second sub-portion 7212 is spaced away from the heat sink 71. A projection of the second sub-portion 7212 along the Z-axis direction overlaps a projection of the third opening 1133 of the accommodation groove 113 along the Z-axis direction. The second sub-portion 7212 covers the third opening 1133 of the accommodation groove 113.

Along the Y-axis direction, the third sub-portion 7213 and the fourth sub-portion 7214 are located on two opposite sides of the heat sink 71, and both the third sub-portion 7213 and the fourth sub-portion 7214 are spaced away from the heat sink 71. In addition, along the Y-axis direction, the third sub-portion 7213 and the fourth sub-portion 7214 are located on two opposite sides of the inductor 60, and both the third sub-portion 7213 and the fourth sub-portion 7214 are spaced away from the inductor 60. Both a projection of the third sub-portion 7213 along the Y-axis direction and a projection of the fourth sub-portion 7214 along the Y-axis direction overlap a projection of the second opening 1132 along the Y-axis direction. The third sub-portion 7213 and the fourth sub-portion 7214 respectively cover the two second openings 1132 of the accommodation groove 113. Along the Z-axis direction, the fifth sub-portion 7215 is located between the inductor 60 and the third cavity wall 111b, and is spaced away from the inductor 60 and the third cavity wall 111b. In some other embodiments, the fifth sub-portion 7215 may alternatively be omitted.

In some embodiments, the stationary portion 721 is provided with a first sliding rail 7216 and a second sliding rail 7216a. Specifically, along the X-axis direction, the first sliding rail 7216 and the second sliding rail 7216a are disposed on one side of the first sub-portion 7211 and face the third sub-portion 7213, and the first sliding rail 7216 and the second sliding rail 7216a are fastened and stacked on one side of the first sub-portion 7211 and face the third sub-portion 7213. Along the Z-axis direction, the first sliding rail 7216 and the second sliding rail 7216a are arranged opposite to each other at a spacing. Both the first sliding rail 7216 and the second sliding rail 7216a extend along the Y-axis direction. The first sliding rail 7216, the second sliding rail 7216a, and the first sub-portion 7211 enclose a sliding slot 723.

In other words, the stationary portion 721 is provided with the sliding slot 723. The sliding slot 723 extends along the X-axis direction (namely, the first direction) and has a sliding slot opening 7231. The sliding slot 723 extends along the Y-axis direction (namely, the second direction) and has a fitting opening 7232. There are two fitting openings 7232. Along the Y-axis direction, the two fitting openings 7232 are arranged back to back. In some other embodiments, a fitting openings 7232 that back the third sub-portion 7213 may be omitted. In other words, there may alternatively be one fitting opening 7232. A projection of the sliding slot 723 along the X-axis direction overlaps a projection of the heat sink 71 along the X-axis direction. Along the X-axis direction (namely, the first direction), the sliding slot opening 7231 of the sliding slot 723 faces the heat sink 71. In addition, along the Z-axis direction, the sliding slot 723 is located on one side of the inductor 60 and faces the heat sink 71, and the sliding slot 723 is spaced away from the inductor 60.

In some embodiments, the stationary portion 721 is provided with a position-limiting portion 7216b. Specifically, along the X-axis direction, the position-limiting portion 7216b is disposed on one side of the first sub-portion 7211 and faces the third sub-portion 7213, and the position-limiting portion 7216b is fastened and stacked on one side of the first sub-portion 7211 and faces the third sub-portion 7213. Along the Y-axis direction, the position-limiting portion 7216b is located on one side of the sliding slot 723 and backs the third sub-portion 7213. A projection of the position-limiting portion 7216b along the Y-axis direction overlaps a projection of the sliding slot 723 along the Y-axis direction.

In some embodiments, the stationary portion 721 is provided with an air intake hole 724. In other words, the air director 72 is provided with the air intake hole 724, and the air intake hole 724 is provided on the stationary portion 721. The air intake hole 724 passes through the stationary portion 721 along the X-axis direction. The air intake hole 724 extends along the X-axis direction (namely, the first direction). The air intake hole 724 is in communication with the accommodation groove 113. Along the Z-axis direction, the air intake hole 724 is located between the first sliding rail 7216 and the second sliding rail 7216a. To be specific, a projection of the air intake hole 724 along the X-axis direction overlaps the projection of the sliding slot 723 along the X-axis direction. Along the Y-axis direction, the air intake hole 724 is located between the position-limiting portion 7216b and the third sub-portion 7213, and is spaced away from the position-limiting portion 7216b and the third sub-portion 7213. For example, there are a plurality of air intake holes 724. Specifically, there are two air intake holes 724. In some other embodiments, there may alternatively be one, three, or more air intake holes 724. Along the Y-axis direction, the plurality of air intake holes 724 are spaced away from each other.

In some embodiments, the stationary portion 721 is provided with an air exhaust hole 725. In other words, the air director 72 is provided with the air exhaust hole 725, and the air exhaust hole 725 is provided on the stationary portion 721. Specifically, both the third sub-portion 7213 and the fourth sub-portion 7214 are provided with air exhaust holes 725. An air exhaust hole 725 provided on the third sub-portion 7213 passes through the third sub-portion 7213 along the Y-axis direction, the air exhaust hole 725 provided on the third sub-portion 7213 extends along the Y-axis direction, and the air exhaust hole 725 is in communication with the accommodation groove 113. It can be understood that the air exhaust hole 725 extends along the Y-axis direction, and the air exhaust hole 725 is in communication with the accommodation groove 113. For example, a plurality of air exhaust holes 725 are provided on the third sub-portion 7213. Specifically, four air exhaust holes 725 are provided on the third sub-portion 7213. In some other embodiments, one, two, or more air exhaust holes 725 may alternatively be provided on the third sub-portion 7213. Along the Z-axis direction, the plurality of air exhaust holes 725 provided on the third sub-portion 7213 are sequentially arranged at spacings.

An air exhaust hole 725 provided on the fourth sub-portion 7214 passes through the fourth sub-portion 7214 along the Y-axis direction, the air exhaust hole 725 provided on the fourth sub-portion 7214 extends along the Y-axis direction, and the air exhaust hole 725 is in communication with the accommodation groove 113. It can be understood that the air exhaust hole 725 extends along the Y-axis direction, and the air exhaust hole 725 is in communication with the accommodation groove 113. For example, a plurality of air exhaust holes 725 are provided on the fourth sub-portion 7214. Specifically, four air exhaust holes 725 are provided on the fourth sub-portion 7214. In some other embodiments, one, two, or more air exhaust holes 725 may alternatively be provided on the fourth sub-portion 7214. Along the Z-axis direction, the plurality of air exhaust holes 725 provided on the fourth sub-portion 7214 are sequentially arranged at spacings.

In some embodiments, the stationary portion 721 is provided with a fitting hole 726. Specifically, the fitting hole 726 passes through the third sub-portion 7213 along the Y-axis direction, and the fitting hole 726 passes through the stationary portion 721 along the Y-axis direction (namely, the second direction). The fitting hole 726 is in communication with the accommodation groove 113. Along the X-axis direction, the fitting hole 726 is located on one side of the air exhaust hole 725 and faces the sliding slot 723. A projection of the fitting hole 726 along the Y-axis direction overlaps the projection of the sliding slot 723 along the X-axis direction. The fitting hole 726 is in communication with the fitting opening 7232 of the sliding slot 723, and the fitting hole 726 is in communication with the sliding slot 723. The fitting hole 726 is in communication with the accommodation groove 113.

In some embodiments, the stationary portion 721 is provided with a first baffle plate 727. Specifically, the first baffle plate 727 is disposed on one side of the first sub-portion 7211 and faces the third sub-portion 7213, and the first baffle plate 727 is fastened to one side of the first sub-portion 7211 and faces the third sub-portion 7213. Along the Y-axis direction, the first baffle plate 727 is located on one side of the plurality of air intake holes 724 and the third sub-portion 7213, and the first baffle plate 727 is spaced away from the plurality of air intake holes 724 and the third sub-portion 7213. The first baffle plate 727 extends along the Z-axis direction, and the first baffle plate 727 is fastened to the second sub-portion 7212 and the fifth sub-portion 7215. The first baffle plate 727 is provided with a first avoidance hole 7271. The first avoidance hole 7271 extends from a side, facing the first sub-portion 7211, of the first baffle plate 727 along the X-axis direction. In addition, the first avoidance hole 7271 passes through the first baffle plate 727 along the Y-axis direction. The first avoidance hole 7271 is configured to accommodate the first sliding rail 7216 and the second sliding rail 7216a.

Along the X-axis direction, the first baffle plate 727 is located between the first sub-portion 7211 and the heat sink 71. In other words, the first baffle plate 727 is disposed on one side of the air director 72. Along the X-axis direction (namely, the first direction), the first baffle plate 727 faces the heat sink 71. The first baffle plate 727 is spaced away from the heat sink 71. In some other embodiments, the first baffle plate 727 may alternatively be in contact with or abut against the heat sink 71. In addition, along the X-axis direction, the first baffle plate 727 is located between the first sub-portion 7211 and the inductor 60.

In some embodiments, the stationary portion 721 is provided with a second baffle plate 727a. Specifically, the second baffle plate 727a is disposed on one side of the first sub-portion 7211 and faces the third sub-portion 7213, and the second baffle plate 727a is fastened to one side of the first sub-portion 7211 and faces the third sub-portion 7213. Along the Y-axis direction, the second baffle plate 727a is located between the plurality of air intake holes 724 and the position-limiting portion 7216b, and the second baffle plate 727a is spaced away from the plurality of air intake holes 724 and the position-limiting portion 7216b. The second baffle plate 727a extends along the Z-axis direction, and the second baffle plate 727a is fastened to the second sub-portion 7212 and the fifth sub-portion 7215. The second baffle plate 727a is provided with a second avoidance hole 7271a. The second avoidance hole 7271a extends from a side, facing the first sub-portion 7211, of the second baffle plate 727a along the X-axis direction. In addition, the second avoidance hole 7271a passes through the second baffle plate 727a along the Y-axis direction. The second avoidance hole 7271a is configured to accommodate the first sliding rail 7216 and the second sliding rail 7216a. It can be understood that, along the Y-axis direction, the first baffle plate 727 and the second baffle plate 727a are located on two sides of the plurality of air intake holes 724, and are spaced away from the plurality of air intake holes 724. In other words, along the Y-axis direction (namely, the second direction), the first baffle plate 727 and the second baffle plate 727a are located on two sides of the air intake hole 724, and are spaced away from the air intake hole 724.

Along the X-axis direction, the second baffle plate 727a is located between the first sub-portion 7211 and the heat sink 71. In other words, the second baffle plate 727a is disposed on one side of the air director 72. Along the X-axis direction (namely, the first direction), the second baffle plate 727a faces the heat sink 71. The second baffle plate 727a is spaced away from the heat sink 71. In some other embodiments, the second baffle plate 727a may alternatively be in contact with or abut against the heat sink 71. In addition, along the X-axis direction, the second baffle plate 727a is located between the first sub-portion 7211 and the inductor 60.

As shown in FIG. 5, FIG. 15, and FIG. 16, in some embodiments, the slidable portion 722 is slidably connected to the sliding slot 723 along the Y-axis direction (namely, the second direction). In addition, the slidable portion 722 movably passes through the fitting hole 726 along the Y-axis direction (namely, the second direction). Specifically, the slidable portion 722 passes through the fitting hole 726 and the fitting opening 7232 of the sliding slot 723 along the Y-axis direction to enter the sliding slot 723, the slidable portion 722 passes through the first avoidance hole 7271 of the first baffle plate 727 and the second avoidance hole 7271a of the second baffle plate 727a in the sliding slot 723 along the Y-axis direction, and then the slidable portion 722 abuts against the position-limiting portion 7216b along the Y-axis direction. In this way, the slidable portion 722 and the stationary portion 721 are assembled, the slidable portion 722 blocks the fitting hole 726, and the slidable portion 722 and the stationary portion 721 jointly cover the accommodation groove 113. The position-limiting portion 7216b is designed to perform position limiting for assembly of the slidable portion 722 and the stationary portion 721, so that the slidable portion 722 can be slidably connected to the sliding slot 723 along the Y-axis direction. This helps reduce assembly difficulty, and helps reduce assembly costs of the air director 72. Along the X-axis direction, the slidable portion 722 is located between the first sub-portion 7211 and the heat sink 71, and the slidable portion 722 is spaced away from the heat sink 71. A projection of the slidable portion 722 along the X-axis direction overlaps the projection of the heat sink 71 along the X-axis direction.

In some embodiments, the slidable portion 722 includes a first installation portion 7221 and a second installation portion 7222. Along the Y-axis direction, the second installation portion 7222 is disposed on one side of the first installation portion 7221, and the second installation portion 7222 is fastened to the side of the first installation portion 7221. The first installation portion 7221 is slidably connected to the sliding slot 723 along the Y-axis direction. The first installation portion 7221 and the second installation portion 7222 may movably pass through the fitting hole 726. When the first installation portion 7221 abuts against the position-limiting portion 7216b, the first installation portion 7221 is located outside the fitting hole 726, the second installation portion 7222 is located in the fitting hole 726, and the second installation portion 7222 blocks the fitting hole 726, so that the slidable portion 722 and the stationary portion 721 jointly cover the accommodation groove 113.

In some embodiments, the slidable portion 722 is provided with an air vent 7223. The air vent 7223 passes through the slidable portion 722 along the X-axis direction, and the air vent 7223 passes through the first installation portion 7221 along the X-axis direction. For example, there are a plurality of air vents 7223. Specifically, there are two air vents 7223. In some other embodiments, there may alternatively be one, three, or more air vents 7223. When the first installation portion 7221 abuts against the position-limiting portion 7216b, the second installation portion 7222 blocks the fitting hole 726, and the slidable portion 722 and the stationary portion 721 jointly cover the accommodation groove 113, projections of the plurality of air vents 7223 along the X-axis direction overlap the plurality of air intake holes 724 in a one-to-one correspondence, and the plurality of air vents 7223 are in communication with the plurality of air intake holes 724 in a one-to-one correspondence. That is, the air vent 7223 is in communication with the air intake hole 724. The air vent 7223 is in communication with the accommodation groove 113, and the air intake hole 724 is in communication with the accommodation groove 113 through the air vent 7223.

In some embodiments, along the X-axis direction, the mounting kit 73 is fastened and stacked on one side of the first sub-portion 7211 and backs the slidable portion 722, the mounting kit 73 is disposed on one side of the first sub-portion 7211 and backs the slidable portion 722, the mounting kit 73 is disposed on one side of the stationary portion 721 and backs the heat sink 71, and the mounting kit 73 is disposed on one side of the air director 72 and backs the first sub-housing 11. In addition, the mounting kit 73 is fastened and stacked on one side of the third cavity wall 111b and backs the second cavity 1122, and the mounting kit 73 is fastened and stacked on one side of the first sub-housing 11 and backs the accommodation cavity 112. For example, there are a plurality of mounting kits 73. Specifically, there are two mounting kits 73. Along the Y-axis direction, the two mounting kits 73 are arranged opposite to each other at a spacing. In some other embodiments, there may alternatively be one, three, or more mounting kits 73.

In some embodiments, each mounting kit 73 includes a first fitting portion 731 and a second fitting portion 732. In other words, the mounting kit 73 includes the first fitting portion 731 and the second fitting portion 732. Along the X-axis direction, the second fitting portion 732 is disposed on one side of the first fitting portion 731. Specifically, the second fitting portion 732 is fastened and stacked on one side of the first fitting portion 731. In a manner including but not limited to screwing, welding, or bonding, along the X-axis direction, the second fitting portion 732 is fastened and stacked on one side of the first sub-portion 7211 and backs the slidable portion 722. In addition, along the X-axis direction, the second fitting portion 732 is fastened and stacked on one side of the third cavity wall 111b and backs the second cavity 1122. Along the X-axis direction, the first fitting portion 731 backs the first sub-portion 7211, and the first fitting portion 731 backs the air director 72. In addition, along the X-axis direction, the first fitting portion 731 backs the third cavity wall 111b, and the first fitting portion 731 backs the first sub-housing 11.

Therefore, along the X-axis direction, the mounting kit 73 is fastened and stacked on one side of the air director 72 and backs the heat sink 71, and the mounting kit 73 is fastened and stacked on one side of the first sub-housing 11 and backs the accommodation cavity 112. In this way, the air director 72 is fastened to the first sub-housing 11 through the mounting kit 73, so that along the X-axis direction, the air director 72 is disposed on one side of the heat sink 71 and backs the first sub-housing 11. The design in which the mounting kit 73 is fastened and stacked on the air director 72 and the first sub-housing 11 helps improve strength of a connection between the mounting kit 73 and the first sub-housing 11 of the air director 72, and helps improve structural stability of the power conversion device 200.

In some embodiments, the first fitting portion 731 includes a first section 7311, a second section 7312, a third section 7313, a fourth section 7314, and a fifth section 7315. Along the X-axis direction, the second section 7312, the third section 7313, the fourth section 7314, and the fifth section 7315 are all disposed on one side of the first section 7311, and the second section 7312, the third section 7313, the fourth section 7314, and the fifth section 7315 are all fastened to the side of the first section 7311. Along the Z-axis direction, the second section 7312, the third section 7313, the fourth section 7314, and the fifth section 7315 are sequentially arranged at spacings. The first section 7311 is fastened to the second fitting portion 732. Along the X-axis direction, the second section 7312, the third section 7313, the fourth section 7314, and the fifth section 7315 back the second fitting portion 732. It can be understood that the fourth section 7314 may be held to hold the mounting kit 73, and the mounting kit 73 may be held to move the power conversion device 200. The design is simple and stable, and processing costs are low. The first section 7311 and the second section 7312 enclose a mounting groove 7316. In other words, the mounting kit 73 is provided with the mounting groove 7316. The mounting groove 7316 extends along the Z-axis direction and has an opening. Along the Z-axis direction, the opening of the mounting groove 7316 faces the third section 7313.

As shown in FIG. 3 and FIG. 4, the mounting kit 73 is mounted on the fitting piece 102 through the mounting groove 7316. Specifically, the second section 7312 of the mounting kit 73 is partially inserted into the fitting slot 1021 of the fitting piece 102. Along the Z-axis direction, the second section 7312 abuts against the fitting piece 102. To be specific, along the Z-axis direction, a groove wall of the mounting groove 7316 abuts against the fitting piece 102. In this way, the power conversion device 200 is mounted on the fitting piece 102 through the mounting kit 73, and the power conversion device 200 is mounted on the carrier 100. The power conversion device 200 is mounted on an external component (for example, the carrier 100) through the mounting groove 7316 of the mounting kit 73. The mounting groove 7316 is designed to meet a mounting requirement of the power conversion device 200, and on this basis, has a simple and stable structure, is easy to design, and helps reduce processing costs.

As shown in FIG. 5, FIG. 15, and FIG. 16, in some embodiments, along the X-axis direction, the fan 74 is disposed on one side of the first installation portion 7221 and backs the first sub-portion 7211, and the fan 74 is disposed on one side of the slidable portion 722 and backs the stationary portion 721. A projection of the fan 74 along the X-axis direction (namely, the first direction) overlaps a projection of the air vent 7223 along the X-axis direction (namely, the first direction). For example, there are a plurality of fans 74. Specifically, there are two fans 74. In some other embodiments, there may alternatively be one, three, or more fans 74. Projections of the plurality of fans 74 along the X-axis direction overlap the projections of the plurality of air vents 7223 along the X-axis direction in a one-to-one correspondence. When the first installation portion 7221 abuts against the position-limiting portion 7216b and the second installation portion 7222 blocks the fitting hole 726, the projections of the plurality of fans 74 along the X-axis direction overlap projections of the plurality of air intake holes 724 along the X-axis direction in a one-to-one correspondence. In other words, the projection of the fan 74 along the X-axis direction (namely, the first direction) overlaps a projection of the air intake hole 724 along the X-axis direction (namely, the first direction). Along the Y-axis direction, the plurality of fans 74 are located between the first baffle plate 727 and the second baffle plate 727a, and are spaced away from the first baffle plate 727 and the second baffle plate 727a. In other words, along the Y-axis direction (namely, the second direction), the first baffle plate 727 and the second baffle plate 727a are located on two sides of the fan 74, and are spaced away from the fan 74.

Along the X-axis direction, each fan 74 is located between the slidable portion 722 and the heat sink 71, and each fan 74 is spaced away from the heat sink 71. In other words, along the X-axis direction (namely, the first direction), the fan 74 is disposed on one side of the air director 72 and faces the heat sink 71, and the fan 74 is spaced away from the heat sink 71. The projection of the fan 74 along the X-axis direction overlaps the projection of the heat sink 71 along the X-axis direction.

The design in which the slidable portion 722 is slidably connected to the sliding slot 723 along the Y-axis direction (namely, the second direction) and the slidable portion 722 movably passes through the fitting hole 726 along the Y-axis direction (namely, the second direction) ensures that the slidable portion 722 can slide relative to the stationary portion 721 along the Y-axis direction (namely, the second direction), and the slidable portion 722 can be pulled out of the fitting hole 726 along the sliding slot 723, so that the fan 74 disposed on the slidable portion 722 can be maintained or repaired. This helps reduce difficulty in maintaining or replacing the fan 74, and facilitates maintenance or replacement of the fan 74.

To be specific, the design in which the slidable portion 722 is slidably connected to the stationary portion 721 along the Y-axis direction (namely, the second direction) and the fan 74 is disposed on one side of the slidable portion 722 and backs the stationary portion 721 ensures that the fan 74 can be maintained or replaced after the slidable portion 722 is driven to slide relative to the stationary portion 721, to avoid removing the air director 72 and then maintaining or replacing the fan 74. This helps reduce difficulty in maintaining or replacing the fan 74, and facilitates maintenance or replacement of the fan 74.

The fan 74 is configured to produce cooling air. The cooling air produced by the fan 74 may flow from the outside of the air director 72 to the heat sink 71 through the air intake hole 724, and then flow out of the air director 72 from the heat sink 71 through the air exhaust hole 725, to dissipate heat for the heat sink 71 and therefore dissipate heat for the power module 30. In addition, the cooling air produced by the fan 74 may flow from the outside of the air director 72 to the inductor 60 through the air intake hole 724, and then flow out of the air director 72 from the inductor 60 through the air exhaust hole 725, to dissipate heat for the inductor 60.

It can be understood that cooling air may flow from the outside of the air director 72 to the heat sink 71 through the air intake hole 724, and then flow out of the air director 72 from the heat sink 71 through the air exhaust hole 725, to dissipate heat for the heat sink 71 and therefore dissipate heat for the power module 30. Cooling air may flow from the outside of the air director 72 to the inductor 60 through the air intake hole 724, and then flow out of the air director 72 from the inductor 60 through the air exhaust hole 725, to dissipate heat for the inductor 60. In the design of the air director 72, cooling air can be directed. This helps improve heat dissipation efficiency for the heat sink 71, helps improve heat dissipation efficiency for the power module 30, and helps improve heat dissipation efficiency for the inductor 60.

The design in which the fan 74 is disposed on one side of the air director 72 and faces the heat sink 71 helps improve space utilization of the power conversion device 200, helps reduce the size of the power conversion device 200 along the first direction, and facilitates a miniaturization design for the power conversion device 200. In addition, the fan 74 can be prevented from being exposed out of the air director 72, so that the design is appealing. In addition, the fan 74 can be prevented from being affected by the external environment during operation. This helps improve service life of the fan 74.

In the design of the first baffle plate 727 and the second baffle plate 727a, cooling air produced by the fan 74 can be directed, to ensure that cooling air flowing into the air director 72 through the air intake hole 724 stably flows to the heat sink 71 along the first direction. This helps improve efficiency of cooling air flowing through the heat sink 71, helps improve heat dissipation efficiency for the heat sink 71, and helps improve heat dissipation efficiency for the power module 30.

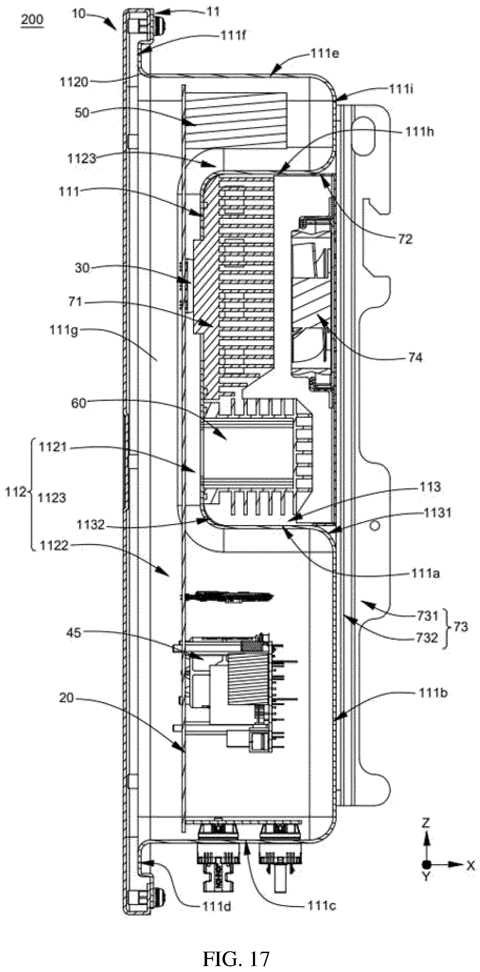

Refer to FIG. 17, in conjunction with FIG. 5. FIG. 17 is a diagram of a structure of the power conversion device 200 shown in FIG. 4 that is cut along the line A-A according to another embodiment.

In some other embodiments, the accommodation cavity 112 includes a third cavity 1123. Along the Z-axis direction (namely, the third direction), the third cavity 1123 is located on one side of the first cavity 1121 and backs the second cavity 1122. The third cavity 1123 is in communication with the first cavity 1121. A depth size of the third cavity 1123 (to be specific, a size of the third cavity 1123 along the X-axis direction) is greater than the depth size of the first cavity 1121 (to be specific, the size of the first cavity 1121 along the X-axis direction). A projection of the third cavity 1123 along the Z-axis direction (namely, the third direction) overlaps the projection of the accommodation groove 113 along the Z-axis direction (namely, the third direction).

Specifically, the first sub-housing 11 includes a first cavity wall 111, a second cavity wall 111a, a third cavity wall 111b, a fourth cavity wall 111c, a fifth cavity wall 111d, a sixth cavity wall 111e, a seventh cavity wall 111f, an eighth cavity wall 111g, a ninth cavity wall 111h, and a tenth cavity wall 111i. For a fitting relationship between the first cavity wall 111, the second cavity wall 111a, the third cavity wall 111b, the fourth cavity wall 111c, and the fifth cavity wall 111d, refer to related descriptions in the embodiment shown in FIG. 5. Details are not described again. Along the Z-axis direction, the sixth cavity wall 111e is located on one side of the first cavity wall 111 and backs the second cavity wall 111a, and the sixth cavity wall 111e is spaced away from the first cavity wall 111. The sixth cavity wall 111e extends along the X-axis direction. Along the X-axis direction, the seventh cavity wall 111f is located on one side of the first cavity wall 111 and backs the second cavity wall 111a, and the seventh cavity wall 111f is spaced away from the first cavity wall 111. Along the X-axis direction, the seventh cavity wall 111f is located on one side of the sixth cavity wall 111e and is connected to the sixth cavity wall 111e. The seventh cavity wall 111f extends along the Z-axis direction.

Along the X-axis direction, the ninth cavity wall 111h is located on one side of the first cavity wall 111 and faces the second cavity wall 111a. The ninth cavity wall 111h is connected to the first cavity wall 111. Along the Z-axis direction, the ninth cavity wall 111h is located on one side of the first cavity wall 111 and faces the sixth cavity wall 111e, and the ninth cavity wall 111h is spaced away from the sixth cavity wall 111e. The ninth cavity wall 111h extends along the X-axis direction. Along the X-axis direction, the tenth cavity wall 111i is located on one side of the ninth cavity wall 111h and backs the first cavity wall 111. In addition, along the X-axis direction, the tenth cavity wall 111i is located on one side of the sixth cavity wall 111e and backs the seventh cavity wall 111f. Along the Z-axis direction, the tenth cavity wall 111i is located between the sixth cavity wall 111e and the ninth cavity wall 111h. The tenth cavity wall 111i is connected to the sixth cavity wall 111e and the ninth cavity wall 111h. The tenth cavity wall 111i extends along the Z-axis direction.

There are two eighth cavity walls 111g. Along the Y-axis direction, one eighth cavity wall 111g is connected to one side of the first cavity wall 111, the second cavity wall 111a, the third cavity wall 111b, the fourth cavity wall 111c, the fifth cavity wall 111d, the sixth cavity wall 111e, the seventh cavity wall 111f, the ninth cavity wall 111h, and the tenth cavity wall 111i, and the other eighth cavity wall 111g is connected to the other side of the first cavity wall 111, the second cavity wall 111a, the third cavity wall 111b, the fourth cavity wall 111c, the fifth cavity wall 111d, the sixth cavity wall 111e, the seventh cavity wall 111f, the ninth cavity wall 111h, and the tenth cavity wall 111i.

The first cavity wall 111, the second cavity wall 111a, the third cavity wall 111b, the fourth cavity wall 111c, the fifth cavity wall 111d, the sixth cavity wall 111e, the seventh cavity wall 111f, the two eighth cavity walls 111g, the ninth cavity wall 111h, and the tenth cavity wall 111i enclose an accommodation cavity 112. The accommodation cavity 112 extends along the X-axis direction and has an accommodation opening 1120. The first cavity wall 111 and the two eighth cavity walls 111g enclose a first cavity 1121. The second cavity wall 111a, the third cavity wall 111b, the fourth cavity wall 111c, and the two eighth cavity walls 111g enclose a second cavity 1122. The sixth cavity wall 111e, the tenth cavity wall 111i, the ninth cavity wall 111h, and the two eighth cavity walls 111g enclose a third cavity 1123.

Therefore, the accommodation cavity 112 includes the first cavity 1121, the second cavity 1122, and the third cavity 1123. Along the Z-axis direction (namely, the third direction), the second cavity 1122 is located on one side of the first cavity 1121. The second cavity 1122 is in communication with the first cavity 1121. Along the Z-axis direction (namely, the third direction), the third cavity 1123 is located on one side of the first cavity 1121 and backs the second cavity 1122. The third cavity 1123 is in communication with the first cavity 1121. A depth size of the second cavity 1122 (to be specific, a size of the second cavity 1122 along the X-axis direction) is greater than a depth size of the first cavity 1121 (to be specific, a size of the first cavity 1121 along the X-axis direction). A depth size of the third cavity 1123 (to be specific, a size of the third cavity 1123 along the X-axis direction) is greater than the depth size of the first cavity 1121 (to be specific, the size of the first cavity 1121 along the X-axis direction).

The first cavity wall 111, the second cavity wall 111a, and the ninth cavity wall 111h enclose an accommodation groove 113. In other words, the accommodation groove 113 is provided on one side of the first sub-housing 11. The accommodation groove 113 extends along the X-axis direction and has a first opening 1131. Along the X-axis direction, the first opening 1131 backs the first cavity 1121, and the first opening 1131 backs the accommodation cavity 112. The accommodation groove 113 extends along the Y-axis direction and has a second opening 1132. There are two second openings 1132, and the two second openings 1132 are arranged back to back. It can be understood that a third opening 1133 of the accommodation groove 113 may be omitted.

A projection of the accommodation groove 113 along the X-axis direction overlaps a projection of the first cavity 1121 along the X-axis direction. Along the Z-axis direction, the accommodation groove 113 is located between the second cavity 1122 and the third cavity 1123. A projection of the accommodation groove 113 along the Z-axis direction overlaps a projection of the second cavity 1122 along the Z-axis direction and a projection of the third cavity 1123 along the Z-axis direction. In other words, the projection of the third cavity 1123 along the Z-axis direction (namely, the third direction) overlaps the projection of the accommodation groove 113 along the Z-axis direction (namely, the third direction).

In this embodiment, the circuit board 20 is accommodated in the first cavity 1121, the second cavity 1122, and the third cavity 1123. Along the X-axis direction, the power module 30 is installed on one side of the circuit board 20 and faces the first cavity wall 111. The power module 30 is accommodated in the first cavity 1121. A projection of the power module 30 along the X-axis direction overlaps the projection of the accommodation groove 113 along the X-axis direction. Along the X-axis direction, the auxiliary module 40 is installed on one side of the circuit board 20 and faces the power module 30. Along the X-axis direction, the auxiliary module 40 is located between the circuit board 20 and the third cavity wall 111b. The auxiliary module 40 is accommodated in the second cavity 1122. A projection of the auxiliary module 40 along the Z-axis direction overlaps the projection of the accommodation groove 113 along the Z-axis direction.

Along the X-axis direction (namely, the first direction), the capacitor 50 is installed on one side of the circuit board 20 and faces the power module 30. Along the X-axis direction, the capacitor 50 is located between the circuit board 20 and the tenth cavity wall 111i. The capacitor 50 is accommodated in the third cavity 1123. A projection of the capacitor 50 along the Z-axis direction (namely, the third direction) overlaps the projection of the accommodation groove 113 along the Z-axis direction (namely, the third direction).

This ensures that the power module 30, the auxiliary module 40, and the capacitor 50 can be accommodated in the accommodation cavity 112. On this basis, the depth size of the first cavity 1121 (to be specific, the size of the first cavity 1121 along the X-axis direction) adapts to a size of the power module 30 along the first direction (namely, the X-axis direction), the depth size of the second cavity 1122 (to be specific, the size of the second cavity 1122 along the X-axis direction) adapts to a size of the auxiliary module 40 along the first direction (namely, the X-axis direction), and the depth size of the third cavity 1123 (to be specific, the size of the third cavity 1123 along the X-axis direction) adapts to a size of the capacitor 50 along the first direction (namely, the X-axis direction).

Compared with the embodiment shown in FIG. 5, in this embodiment, the capacitor 50 is accommodated in the third cavity 1123. The design in which the capacitor 50 is accommodated in the third cavity 1123 can ensure that the projection of the capacitor 50 along the Z-axis direction (namely, the third direction) overlaps the projection of the accommodation groove 113 along the Z-axis direction (namely, the third direction). This helps improve space utilization of the accommodation cavity 112, helps reduce the size of the housing 10 along the X-axis direction (namely, the first direction), helps improve space utilization of the housing 10, facilitates a miniaturization design for the housing 10, facilitates a miniaturization design for the power conversion device 200, and helps improve power density of the power conversion device 200.

In this way, a shape of the accommodation cavity 112 also adapts to a shape of the circuit board 20, a shape of the power module 30, a shape of the auxiliary module 40, and a shape of the capacitor 50, and the accommodation cavity 112 is filled with the circuit board 20, the power module 30, the auxiliary module 40, and the capacitor 50 at high density. This greatly improves space utilization of the accommodation cavity 112, helps improve space utilization of the housing 10, facilitates a miniaturization design for the housing 10, facilitates a miniaturization design for the power conversion device 200, and helps improve power density of the power conversion device 200.

In this embodiment, the heat sink 71 and the inductor 60 are accommodated in the accommodation groove 113. Along the X-axis direction, the air director 72 is disposed on one side of the heat sink 71 and backs the first sub-housing 11, the air director 72 is disposed on one side of the inductor 60 and backs the first sub-housing 11, the air director 72 covers the outside of the heat sink 71 and the outside of the inductor 60, and the air director 72 covers the accommodation groove 113. The fan 74 is disposed on one side of the air director 72 and faces the heat sink 71. For details, refer to related descriptions in the embodiment shown in FIG. 5. Details are not described again.

Along the X-axis direction, the mounting kit 73 is disposed on one side of the air director 72 and backs the heat sink 71. In addition, along the X-axis direction, the mounting kit 73 is disposed on one side of the first sub-housing 11 and backs the accommodation cavity 112. Specifically, along the X-axis direction, the second fitting portion 732 of the mounting kit 73 is fastened and stacked on one side of the air director 72 and backs the heat sink 71. In addition, along the X-axis direction, the second fitting portion 732 is fastened and stacked on one side of the tenth cavity wall 111i and backs the third cavity 1123, and the second fitting portion 732 is fastened and stacked on one side of the third cavity wall 111b and backs the second cavity 1122. Along the X-axis direction, the first fitting portion 731 backs the first sub-housing 11, and the first fitting portion 731 backs the heat sink 71. In this way, the air director 72 is fastened to the first sub-housing 11 through the mounting kit 73, so that along the X-axis direction, the air director 72 can be disposed on one side of the heat sink 71 and back the first sub-housing 11, the air director 72 is disposed on one side of the inductor 60 and backs the first sub-housing 11, the air director 72 covers the outside of the heat sink 71 and the outside of the inductor 60, and the air director 72 covers the accommodation groove 113.

Compared with the embodiment shown in FIG. 5, in this embodiment, the second fitting portion 732 is fastened and stacked on the tenth cavity wall 111i, the second fitting portion 732 is fastened and stacked on the third cavity wall 111b, and the mounting kit 73 is fastened and stacked on the first sub-housing 11. This helps increase a contact area between the mounting kit 73 and the first sub-housing 11, helps improve strength of a connection between the mounting kit 73 and the first sub-housing 11, and helps improve structural stability of the power conversion device 200.

Still refer to FIG. 4, FIG. 5, and FIG. 17. An embodiment of this application provides a power conversion device 200. The power conversion device 200 includes a housing 10, a power module 30, and a heat sink 71. The housing 10 includes a first sub-housing 11 and a second sub-housing 12. The first sub-housing 11 includes an accommodation cavity 112, and the accommodation cavity 112 extends along an X-axis direction (namely, a first direction) and has an accommodation opening 1120. Along the X-axis direction (namely, the first direction), the second sub-housing 12 is disposed on one side of the first sub-housing 11, and the second sub-housing 12 covers the accommodation opening 1120 and closes the accommodation cavity 112. The power module 30 is accommodated in the accommodation cavity 112. Along the X-axis direction (namely, the first direction), the heat sink 71 is disposed on one side of the first sub-housing 11 and backs the second sub-housing 12. The heat sink 71 is connected to the power module 30 in a thermally conductive manner. An accommodation groove 113 is provided on one side of the first sub-housing 11. The accommodation groove 113 extends along the X-axis direction (namely, the first direction) and has a first opening 1131. Along the X-axis direction (namely, the first direction), the first opening 1131 of the accommodation groove 113 backs the accommodation cavity 112. The heat sink 71 is accommodated in the accommodation groove 113.

In the power conversion device 200 provided in this embodiment of this application, heat generated by the power module 30 during operation is transferred out of the housing 10 through the heat sink 71, to quickly dissipate heat for the power module 30. Compared with an existing power conversion device 200, in the power conversion device 200 provided in this application, because the heat sink 71 is accommodated in the accommodation groove 113, space utilization of the housing 10 is greatly improved while heat dissipation efficiency for the power module 30 is ensured. This helps reduce a size of the power conversion device 200 along the first direction, and facilitates a miniaturization design for the power conversion device 200.

## Claims

1. A power conversion device, comprising:
a housing, wherein the housing comprises a first sub-housing and a second sub-housing, the first sub-housing comprises an accommodation cavity, the accommodation cavity extends along a first direction and has an accommodation opening, the second sub-housing is disposed on one side of the first sub-housing along the first direction, and the second sub-housing covers the accommodation opening and closes the accommodation cavity;
a power module, wherein the power module is accommodated in the accommodation cavity; and
a heat sink, wherein along the first direction, the heat sink is disposed on one side of the first sub-housing and backs the second sub-housing; and the heat sink is connected to the power module in a thermally conductive manner, wherein
an accommodation groove is provided on one side of the first sub-housing, the accommodation groove extends along the first direction and has a first opening, the first opening of the accommodation groove backs the accommodation cavity along the first direction, and the heat sink is accommodated in the accommodation groove.

2. The power conversion device according to claim 1, wherein the first sub-housing is provided with a first through hole, the first through hole passes through the first sub-housing along the first direction, the first through hole is in communication with the accommodation cavity and the accommodation groove, the heat sink is exposed to the accommodation cavity through the first through hole, and the heat sink is in contact with the power module.

3. The power conversion device according to claim 1, wherein the accommodation groove passes through the first sub-housing along a second direction and has a second opening, the heat sink is exposed out of the housing through the first opening and the second opening, and the second direction is perpendicular to the first direction.

4. The power conversion device according to any one of claims 1 to 3, wherein the power conversion device comprises a circuit board and an inductor; the circuit board is accommodated in the accommodation cavity; along the first direction, the circuit board is installed on one side of the power module and backs the first sub-housing; the inductor is accommodated in the accommodation groove; the inductor is spaced away from the heat sink; and the inductor is electrically connected to the circuit board.

5. The power conversion device according to claim 4, wherein the first sub-housing is provided with a second through hole, the second through hole passes through the first sub-housing along the first direction, the second through hole is in communication with the accommodation cavity and the accommodation groove, the second through hole is spaced away from the first through hole, the power conversion device comprises a connector, the connector passes through the second through hole, and the connector is disposed between the inductor and the circuit board; or
the inductor passes through the second through hole, and the inductor is plug-connected to the circuit board.

6. The power conversion device according to claim 4, wherein the inductor comprises an inductor housing and an inductor body, an installation slot is provided on one side of the inductor housing, the installation slot extends along the first direction and has an opening, the opening of the installation slot faces the accommodation cavity along the first direction, the inductor body is accommodated in the installation slot, the inductor body is electrically connected to the circuit board, the inductor housing is provided with a thermally conductive fin, and the thermally conductive fin is located outside the installation slot.

7. The power conversion device according to claim 4, wherein the power conversion device comprises an auxiliary module; along the first direction, the auxiliary module is installed on one side of the circuit board and faces the power module; the auxiliary module is accommodated in the accommodation cavity; a projection of the auxiliary module along a third direction overlaps a projection of the accommodation groove along the third direction; and the third direction is perpendicular to the first direction.

8. The power conversion device according to claim 7, wherein the accommodation cavity comprises a first cavity and a second cavity; along the third direction, the second cavity is located on one side of the first cavity and is in communication with the second cavity; a depth size of the second cavity is greater than a depth size of the first cavity; a projection of the first cavity along the first direction overlaps a projection of the accommodation groove along the first direction; a projection of the second cavity along the third direction overlaps the projection of the accommodation groove along the third direction; the power module is accommodated in the first cavity, and the auxiliary module is accommodated in the second cavity.

9. The power conversion device according to claim 8, wherein the power conversion device comprises a capacitor; along the first direction, the capacitor is installed on one side of the circuit board and faces the power module; the capacitor is accommodated in the second cavity; the capacitor is spaced away from the auxiliary module; and a projection of the capacitor along the third direction overlaps the projection of the accommodation groove along the third direction.

10. The power conversion device according to claim 8, wherein the accommodation cavity comprises a third cavity; along the third direction, the third cavity is located on one side of the first cavity and backs the second cavity; the third cavity is in communication with the first cavity; a depth size of the third cavity is greater than the depth size of the first cavity; and a projection of the third cavity along the third direction overlaps the projection of the accommodation groove along the third direction; and
the power conversion device comprises a capacitor, wherein along the first direction, the capacitor is installed on one side of the circuit board and faces the power module; the capacitor is accommodated in the third cavity; and a projection of the capacitor along the third direction overlaps the projection of the accommodation groove along the third direction.

11. The power conversion device according to claim 1, wherein the power conversion device comprises an air director; along the first direction, the air director is disposed on one side of the heat sink and backs the first sub-housing, the air director covers the accommodation groove; the air director is provided with an air intake hole and an air exhaust hole; the air intake hole extends along the first direction; the air intake hole is in communication with the accommodation groove; the air exhaust hole extends along a second direction; the air exhaust hole is in communication with the accommodation groove; and the second direction is perpendicular to the first direction.

12. The power conversion device according to claim 11, wherein the power conversion device comprises a fan; along the first direction, the fan is disposed on one side of the air director and faces the heat sink; the fan is spaced away from the heat sink; and a projection of the fan along the first direction overlaps a projection of the air intake hole along the first direction.

13. The power conversion device according to claim 12, wherein a first baffle plate and a second baffle plate are disposed on one side of the air director, both the first baffle plate and the second baffle plate face the heat sink along the first direction, and the first baffle plate and the second baffle plate are located on two sides of the fan and are spaced away from the fan along the second direction.

14. The power conversion device according to claim 12, wherein the air director comprises a stationary portion and a slidable portion; the slidable portion is slidably connected to the stationary portion along the second direction; along the first direction, the stationary portion is disposed on one side of the heat sink and backs the first sub-housing; the slidable portion is located between the stationary portion and the heat sink; and both the air intake hole and the air exhaust hole are provided on the stationary portion; and
the slidable portion is provided with an air vent, the air vent is in communication with the air intake hole, the fan is disposed on one side of the slidable portion and backs the stationary portion, and the projection of the fan along the first direction overlaps a projection of the air vent along the first direction.

15. The power conversion device according to claim 14, wherein the stationary portion is provided with a sliding slot, the sliding slot extends along the second direction, the sliding slot extends along the first direction and has a sliding slot opening, the sliding slot opening faces the heat sink along the first direction, the stationary portion is provided with a fitting hole, the fitting hole passes through the stationary portion along the second direction, the slidable portion is slidably connected to the sliding slot along the second direction, and the slidable portion movably passes through the fitting hole along the second direction.
